# EUROPEAN PATENT APPLICATION

(11) **EP 1 750 136 A1**
(43) Date of publication of application: **07.02.2007**
(21) Application number: 05741521.8
(22) Date of filing: 18.05.2005
(51) Int. Cl.: G01R 1/073, G01R 31/26, H01L 21/66

(54) **SHEET-LIKE PROBE, METHOD OF PRODUCING THE PROBE, AND APPLICATION OF THE PROBE**

(30) Priority: 19.05.2004 JP 2004149558
(71) Applicant: JSR Corporation, Tokyo 104-0045 (JP)
(72) Inventor: SATO, Katsumi, Tokyo 1040045 (JP); INOUE, Kazuo, Tokyo 1040045 (JP); MOCHIZUKI, Isamu, Tokyo 1040045 (JP); HIRASAWA, Hiroyuki, Tokyo 1040045 (JP)
(74) Representative: TBK-Patent
(86) International application number: PCT/JP2005/009048
(87) International publication number: WO 2005/111632

(57) **Abstract**

Disclosed herein are a sheet-like probe that permits forming a front-surface electrode part small in diameter and surely achieving a stable electrically connected state even to a circuit device, on which electrodes have been formed at a small pitch, and prevents the electrode structures from falling off from an insulating film to achieve high durability, and a production process and applications thereof. The sheet-like probe of the invention has a contact film obtained by arranging, in a flexible insulating film, a plurality of electrode structures extending through in a thickness-wise direction of the insulating film in a state separated from one another in a plane direction of the insulating film, wherein each of the electrode structures is exposed to the surfaces of the insulating film and composed of a front-surface electrode part projected from a front surface of the insulating film, a back-surface electrode part exposed to a back surface of the insulating film, a short circuit part directly joined to the front-surface electrode part and the back-surface electrode part for electrically connecting them and extending in a thickness-wise direction of the insulating film, and a holding part formed at a proximal end portion of the front-surface electrode part and extending in the plane direction of the insulating film, and at least a part of the holding part is embedded in the insulating film.

## Description

### TECHNICAL FIELD

The present invention relates to a sheet-like probe for conducting electrical connection to circuits, for examples, integrated circuits or the like, in electrical inspection of the circuits, and a production process and applications thereof.

### BACKGROUND ART

In electrical inspection of circuit devices of, for example, wafers, on which a great number of integrated circuits have been formed, or electronic parts such as semiconductor devices, a probe card having inspection electrodes arranged in accordance with a pattern corresponding to a pattern of electrodes to be inspected of a circuit device to be inspected is used. As such a probe card, is used that, on which inspection electrodes (probes) each composed of a pin or blade are arranged.

When the circuit device to be inspected is a wafer, on which a great number of integrated circuits have been formed, it is however necessary to arrange a very great number of inspection electrodes upon production of a probe card for inspecting the wafer, so that such a probe card becomes extremely expensive. In addition, when the pitch of electrodes to be inspected is small, the production itself of the probe card becomes difficult. Further, since warpage generally occurs on wafers, and the condition of the warpage varies with individual products (wafers), it is difficult in fact to bring the inspection electrodes of the probe card into stable and sure contact with a great number of the electrodes to be inspected on the wafer, respectively.

For the above reasons, in recent years, there has been proposed, as a probe card for inspecting integrated circuits formed on a wafer, a probe card comprising a circuit board for inspection, on one surface of which a plurality of inspection electrodes have been formed in accordance with a pattern corresponding to a pattern of electrodes to be inspected, an anisotropically conductive sheet arranged on said one surface of the circuit board for inspection and a sheet-like probe arranged on the anisotropically conductive sheet, said sheet-like probe being obtained by arranging, in a flexible insulating film, a plurality of electrode structures each extending through in a thickness-wise direction of the insulating film (see, for example, the following Prior Art. 1).

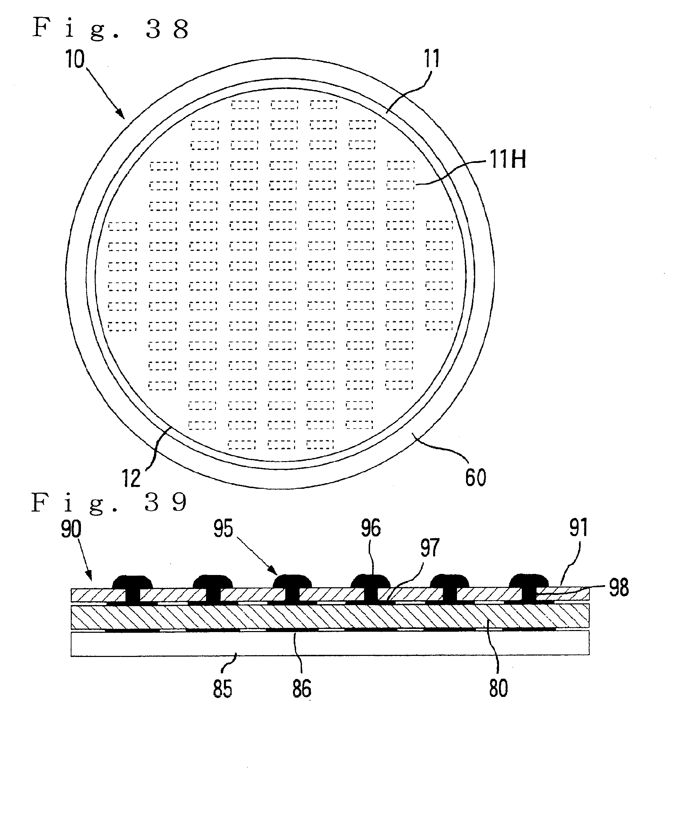

Fig. 39 is a cross-sectional view illustrating the construction of an exemplary conventional probe card comprising a circuit board for inspection, an anisotropically conductive sheet and a sheet-like probe. In this probe card, a circuit board 85 for inspection having, on one surface thereof, a great number of inspection electrodes 86 formed in accordance with a pattern corresponding to a pattern of electrodes to be inspected of a circuit device to be inspected is provided, and a sheet-like probe 90 is arranged on said one surface of this circuit board 85 for inspection through an anisotropically conductive sheet 80.

The anisotropically conductive sheet 80 is a sheet exhibiting conductivity only in its thickness-wise direction or having pressure-sensitive conductive conductor parts exhibiting conductivity only in their thickness-wise direction when they are pressurized in the thickness-wise direction. As such anisotropically conductive sheets, those of various structures are known. For example, Patent Art. 2 or the like discloses an anisotropically conductive sheet (hereinafter referred to as "dispersion type anisotropically conductive sheet") obtained by uniformly dispersing metal particles in an elastomer, and Prior Art. 3 or the like discloses an anisotropically conductive sheet (hereinafter referred to as "uneven distribution type anisotropically conductive sheet") obtained by unevenly distributing particles of a conductive magnetic substance in an elastomer to form a great number of conductive parts extending in a thickness-wise direction thereof and an insulating part for mutually insulating them. Further, Patent Art. 4 or the like discloses an uneven distribution type anisotropically conductive sheet with a difference in level defined between the surface of each conductive part and an insulating part.

The sheet-like probe 90 has a flexible insulating film 91 composed of, for example, a resin. In this insulating film 91, a plurality of electrode structures 95 extending in a thickness-wise direction of the sheet are arranged in accordance with a pattern corresponding to a pattern of electrodes to be inspected of a circuit device to be inspected. Each of the electrode structures 95 is formed by integrally connecting a projected front-surface electrode part 96 exposed to a front surface of the insulating film 91 and a plate-like back-surface electrode part 97 exposed to a back surface of the insulating film 91 to each other through a short circuit part 98 extending through in the thickness-wise direction of the insulating film 91.

Such a sheet-like probe 90 is generally produced in the following manner.

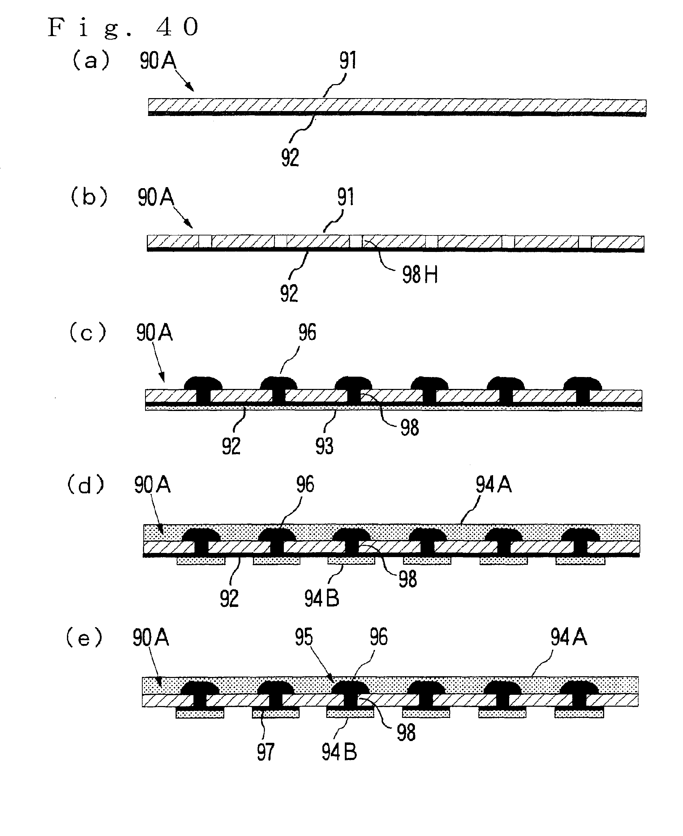

As illustrated in Fig. 40(a), a laminate material 90A obtained by forming a metal layer 92 on one surface of an insulating film 91 is first provided, and through-holes 98H each extending through in a thickness-wise direction of the insulating film 91 are formed in the insulating sheet 91 as illustrated in Fig. 40(b).

As illustrated in Fig. 40(c), a resist film 93 is then formed on the metal layer 92 on the insulating sheet 91, and an electroplating treatment is conducted by using the metal layer 92 as a common electrode, whereby metal deposit is filled into the through-holes 98H in the insulating film 91 to form short circuit parts 98 integrally joined to the metal layer 92, and at the same time, projected front-surface electrode parts 96 integrally joined to the respective short circuit parts 98 are formed on the front surface of the insulating film 91.

Thereafter, the resist film 93 is removed from the metal layer 92, and as illustrated in Fig. 40(d), a resist film 94A is formed on the front surface of the insulating film 91 including the front-surface electrode parts 96, and moreover resist film portions 94B are formed on the metal layer 92 in accordance with a pattern corresponding to a pattern of back-surface electrode parts to be formed. The metal layer 92 is subjected to an etching treatment to remove exposed portions of the metal layer 92, thereby forming back-surface electrode parts 97 as illustrated in Fig. 40(e), thus resulting in the formation of the electrode structures 95.

The resist film 94A formed on the insulating film 91 and front-surface electrode parts 96 is removed, and at the same time the resist film portions 94B formed on the back-surface electrode parts 97 are removed, thereby obtaining the sheet-like probe 90.

In the above-described probe card, the front-surface electrode parts 96 of the electrode structures 95 in the sheet-like probe 90 are arranged on the surface of a circuit device to be inspected, for example, a wafer, so as to be located on electrodes to be inspected of the wafer. In this state, the wafer is pressed by the probe card, whereby the anisotropically conductive sheet 80 is pressed by the back-surface electrode parts 97 of the electrode structures 95 in the sheet-like probe 90, and in the anisotropically conductive sheet 80, conductive paths are thereby formed between the back-surface electrode parts 97 and the inspection electrodes 86 of the circuit board 85 for inspection in the thickness-wise direction of the anisotropically conductive sheet 80. As a result, electrical connection of the electrodes to be inspected of the wafer to the inspection electrodes 86 of the circuit board 85 for inspection is achieved. In this state, necessary electrical inspection as to the wafer is then performed.

According to such a probe card, the anisotropically conductive sheet is deformed according to the degree of warpage of the wafer when the wafer is pressed by the probe card, so that good electrical connection to each of a great number of the electrodes to be inspected in the wafer can be surely achieved.

However, the sheet-like probe in the above-described probe card involves the following problems.

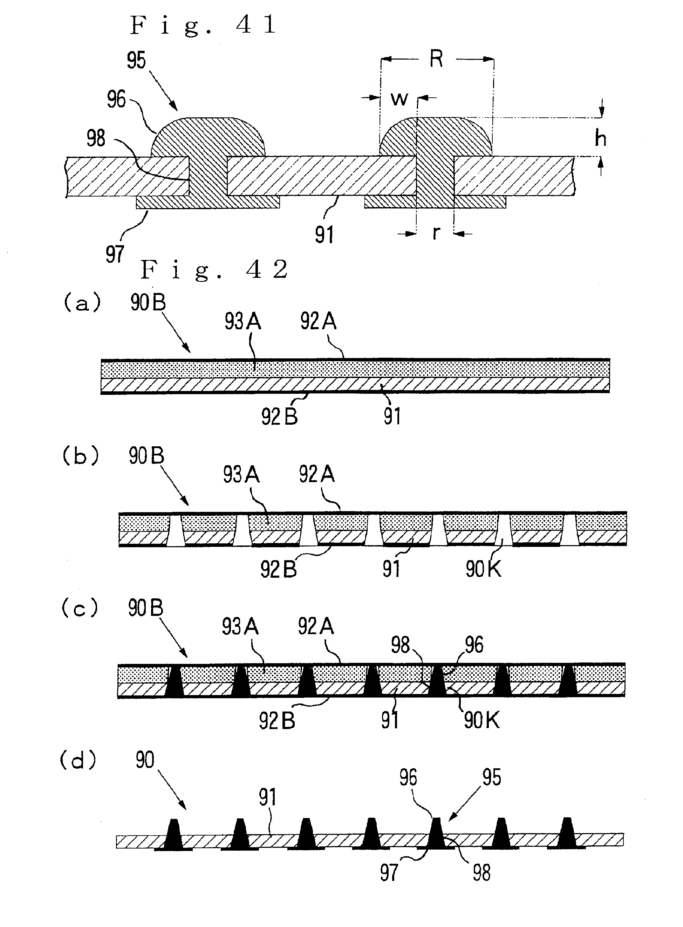

In the step of forming the short circuit parts 98 and front-surface electrode parts 96 in the production process of the sheet-like probe, the plated layer by the electroplating isotropically grows. Therefore, in each front-surface electrode part 96 to be obtained, a distance w from a periphery of the front-surface electrode part 96 to a periphery of the short circuit part 98 becomes equivalent to the projected height h of the front-surface electrode part 96 as illustrated in Fig. 41. Accordingly, the diameter R of the resultant front-surface electrode part 96 becomes considerably large exceeding twice of the projected height h. When the electrodes to be inspected in the circuit device to be inspected are minute and arranged at an extremely small pitch, a clearance between electrode structures 95 adjoining each other thus cannot be sufficiently secured. As a result, in the resulting sheet-like probe, the flexibility by virtue of the insulating film 91 is lost, so that it is difficult to achieve stable electrical connection to the circuit device to be inspected.

In addition, since it is difficult in fact to supply a current even in current density distribution to the overall surface of the metal layer 92 in the electroplating treatment, the growing rate of the plated layer varies with individual through-holes 98H in the insulating film 91 due to the unevenness of the current density distribution, so that a wide scatter occurs on the projected height h of the front-surface electrode parts 96 formed and the distance w from the periphery of the front-surface electrode part 96 to the periphery of the short circuit part 98, i.e., the diameter R. If a wide scatter occurs on the projected height h of the front-surface electrode parts 96, stable electrical connection to the circuit device to be inspected becomes difficult. If a wide scatter occurs on the diameter of the front-surface electrode parts 96 on the other hand, there is a possibility that front-surface electrode parts 96 adjoining each other may short-circuit each other.

In order to solve the above problems, as means for making the diameter of the resulting front-surface electrode parts 96 small, are considered a means of making the projected height h of the front-surface electrode parts 96 small, and a means of making the diameter (smallest length in the case where the sectional form is not circular) r of the short circuit parts 98 small, i.e., making the diameter of the through-holes 98H in the insulating film 91 small. In a sheet-like probe obtained by the former means, however, it is difficult to surely achieve stable electrical connection to the electrodes to be inspected. On the other hand, in the latter means, the formation itself of the short circuit parts 98 and front-surface electrode parts 96 by the electroplating treatment becomes difficult.

In order to solve such problems, a sheet-like probe obtained by arranging a great number of electrode structures each having a tapered front-surface electrode part, the diameter of which becomes gradually small from the proximal end toward the distal end, is proposed in Patent Art. 5 and Patent Art. 6.

The sheet-like probe described in Patent Art. 5 is produced in the following manner.

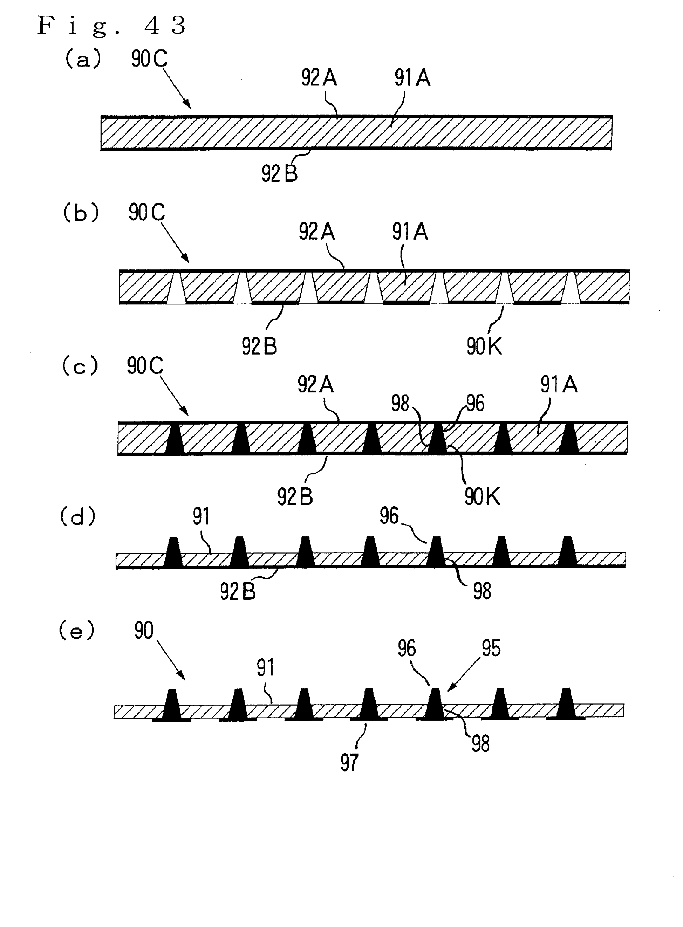

As illustrated in Fig. 42(a), a laminate material 90B obtained by forming a resist film 93A and a front surface-side metal layer 92A on a front surface of an insulating film 91 in this order, and laminating a back surface-side metal layer 92B on a back surface of the insulating sheet 91 is provided. As illustrated in Fig. 42(b), through-holes each extending through the back surface-side metal layer 92B, insulating film 91 and resist film 93A in the laminate material 90B in a thickness-wise direction thereof are formed, thereby forming, in the back surface of the laminate material 90B, recesses 90K for forming electrode structures, which each have a tapered form fitted to a short circuit part and a front-surface electrode part of an electrode structure to be formed. As illustrated in Fig. 42(c), a plating treatment is then conducted by using the front surface-side metal layer 92A in the laminate material 90B as an electrode, thereby filling a metal into the recesses 90K for forming electrode structures to form front-surface electrode parts 96 and short circuit parts 98. The back surface-side metal layer in the laminate material is then subjected to an etching treatment to remove a part thereof, thereby forming back-surface electrode parts 97 as illustrated in Fig. 42(d), thus obtaining the sheet-like probe.

The sheet-like probe described in Patent Art. 6 is produced in the following manner.

As illustrated in Fig. 43(a), a laminate material 90C obtained by forming a front surface-side metal layer 92A on a front surface of an insulating film material 91A having a thickness greater than an insulating film in a sheet-like probe to be formed and laminating a back surface-side metal layer 92B on a back surface of the insulating film material 91A is provided. As illustrated in Fig. 43(b), through-holes each extending through the back surface-side metal layer 92B and insulating film material 91A in the laminate material 90C in a thickness-wise direction thereof are formed, thereby forming, in the back surface of the laminate material 90C, recesses 90K for forming electrode structures, which each have a tapered form fitted to a short circuit part and a front-surface electrode part of an electrode structure to be formed. A plating treatment is then conducted by using the front surface-side metal layer 92A in the laminate material 90C as an electrode, thereby filling a metal into the recesses 90K for forming electrode structures as illustrated in Fig. 43(c) to form front-surface electrode parts 96 and short circuit parts 98. Thereafter, the front surface-side metal layer 92A in the laminate material 90C is removed, and moreover the insulating film material 91A is subjected to an etching treatment to remove the front surface-side portion of the insulating film, thereby forming an insulating film 91 having a necessary thickness and exposing the front-surface electrode parts 96 as illustrated in Fig. 43(d). The back surface-side metal layer 92B is then subjected to an etching treatment, thereby forming back-surface electrode parts 97, thus obtaining the sheet-like probe.

According to such a sheet-like probe, the front-surface electrode parts small in diameter and high in projected height can be formed in a state that a clearance between front-surface electrode parts of electrode structures adjoining each other has been sufficiently secured, since the front-surface electrode parts are in a tapered form. In addition, since the front-surface electrode parts of the respective electrode structures are formed by using the recesses for forming the electrode structures formed in the laminate material as cavities, the electrode structures can be provided as electrode structures narrow in a scatter of projected height of the front-surface electrode parts.

In these sheet-like probes, however, the diameter of the front-surface electrode parts in the electrode structures is equivalent to or smaller than the diameter of the short circuit parts, i.e., the diameter of the through-holes formed in the insulating film, so that the electrode structures fall off from the back surface of the insulating film, resulting in the difficulty of actually using such a sheet-like probe.

In order to solve such a problem, a sheet-like probe obtained by forming, in each of electrode structures, a holding part continuously extending from a proximal end portion of a front-surface electrode part outward along a front surface of an insulating film is proposed in Patent Art. 7.

The holding part in the electrode structure of this sheet-like probe is formed by etching a metal layer formed on the front surface of the insulating film.

However, in such a sheet-like probe, the holding part in the electrode structure is prematurely separated from the insulating film, and the separated holding part is broken, so that it loses the function as the holding part, resulting in the difficulty of achieving high durability.

The sheet-like probes in the above-described probe cards involve the following problems.

The short circuit part 98 in each electrode structure is preferably formed by a material relatively low in electric resistance, for example, a metal such as copper or nickel for the purpose of obtaining good conductivity. On the other hand, the front-surface electrode part 96 in the electrode structure varies in required performance according to the material of electrodes to be inspected of a circuit device that is an object of inspection. For example, when the electrodes to be inspected are composed of solder, the front-surface electrode part is preferably composed of a material hard to be altered by the solder. When the electrodes to be inspected are composed of aluminum, an oxide film is formed on the surfaces thereof. Therefore, the front-surface electrode part is preferably composed of a material having such hardness that the oxide film on the electrodes to be inspected is broken.

However, in the above-described production processes of the sheet-like probes, the short circuit part and front-surface electrode part are continuously formed by the plating treatment, whereby both parts come to be composed of the same material as each other. It is thus difficult to form electrode structures satisfying both performance characteristics required of the front-surface electrode part and short circuit part.

In order to solve such a problem, there are proposed a means for laminating a plurality of metal layers on each surface of front-surface electrode parts and forming an outermost metal layer with a metal having high hardness (see, for example, Patent Art. 8), and a means for forming a coating layer containing fine particles on each surface of front-surface electrode parts (see, for example, Patent Art. 9).

However, in these means, a thin film of a metal different from the front-surface electrode parts is formed as the outermost layer of each front-surface electrode part, and it is thus difficult to make the hardness of the whole front-surface electrode part high, so that the shape of the front-surface electrode part itself is changed by contact under pressure upon repeated use, and so the resulting electrode structures tend to be deteriorated in contact stability. In addition, when such a surface layer is formed by plating upon production of a sheet-like probe having minute electrode structures at a small pitch, there is a problem that a surface plated layer short-circuited to adjoining electrode structures is formed. Therefore, such means have involved a problem that difficulty is encountered upon their application to the production of the sheet-like probe having minute electrode structures at a small pitch.

On the other hand, as a means for forming electrode structures the front-surface electrode parts of which are composed of a material different from other parts, there is proposed a method in which front-surface electrode parts are formed separately from other parts and joined to their corresponding other parts formed in an insulating film with a low-melting metal or an adhesive resin (see, for example, Patent Art. 10 and Patent Art. 11).

However, such a method requires positioning the front-surface electrode parts to other parts and thus involves a problem that the positioning becomes more difficult as the pitch of electrode structures to be formed becomes smaller.

In addition, when the front-surface electrode parts are joined to the other parts with the low-melting metal, there is a problem that joints tend to be deformed upon repeated use because the low-melting metal has low hardness.

Further, when the front-surface electrode parts are joined to the other parts with the adhesive resin, the adhesive resin comes to remain between the front-surface electrode parts and the other parts, and so there is a problem that difficulty is encountered upon formation of electrode structures having good conductivity, since the adhesive resin has an insulating property.

The sheet-like probes in the conventional probe cards involve the following additional problems.

On, for example, a wafer having a diameter of at least 8 inches, at least 5,000 or 10,000 electrodes to be inspected are formed, and a pitch between the electrodes to be inspected is 160 µm or smaller. It is thus necessary to use, as a sheet-like probe for conducting inspection of such a wafer, that having a large area corresponding to the wafer and at least 5,000 or 10,000 electrode structures arranged at a pitch of 160 µm or smaller.

The coefficient of linear thermal expansion of a material forming the wafer, for example, silicon is about 3.3 x 10⁻⁶/K, while the coefficient of linear thermal expansion of a material forming an insulating film in the sheet-like probe, for example, polyimide is about 4.5 x 10⁻⁵/K. Accordingly, when a wafer and a sheet-like probe each having a diameter of, for example, 30 cm at 25°C are heated from 20°C to 120°C, a change of the diameter of the wafer is only 99 µm, while a change of the diameter of the insulating film in the sheet-like probe amounts to 1,350 µm theoretically, so that a difference in thermal expansion between both is 1,251 µm.

When a great difference is caused in the absolute quantity of thermal expansion in a plane direction between the wafer and the insulating film in the sheet-like probe as described above, it is difficult to surely prevent positional deviation between the electrode structures and the electrodes to be inspected by temperature changes in a burn-in test even when the peripheral edge portion of the insulating film is fixed by a holding member having a coefficient of linear thermal expansion equivalent to the coefficient of linear thermal expansion of the wafer, so that a good electrically connected state cannot be stably retained.

In addition, even when the object of inspection is a small-sized circuit device, it is difficult to surely prevent positional deviation between the electrode structures and the electrodes to be inspected by temperature changes in the burn-in test when a pitch between the electrodes to be inspected is 50 µm or smaller, so that a good electrically connected state cannot be stably retained.

In order to solve such a problem, Patent Art. 12 proposes a means for relaxing the thermal expansion of the insulating sheet by fixing the insulating film to a holding member in a state tension has been applied to the insulating film.

However, it is extremely difficult to apply the tension to the insulating film evenly in all directions of the plane direction thereof in such a means. In addition, a balance of the tension applied to the insulating film is changed by forming the electrode structures. As a result, the insulating film comes to have anisotropy on thermal expansion, so that thermal expansion in one direction of the plane direction can be suppressed, whereas thermal expansion in other directions intersecting said one direction cannot be suppressed. After all, the positional deviation between the electrode structures and the electrodes to be inspected by temperature changes cannot be prevented.
Patent Art. 1: Japanese Patent Application Laid-Open No. 231019/1995;
Patent Art. 2: Japanese Patent Application Laid-Open No. 93393/1976;
Patent Art. 3: Japanese Patent Application Laid-Open No. 147772/1978;
Patent Art. 4: Japanese Patent Application Laid-Open No. 250906/1986;
Patent Art. 5: Japanese Patent Application Laid-Open No. 326378/1999;
Patent Art. 6: Japanese Patent Application Laid-Open No. 2002-196018.
Patent Art. 7: International Publication No. 2004/038433 Pamphlet
Patent Art. 8: Japanese Patent Application Laid-Open No. 321169/1995;
Patent Art. 9: Japanese Patent Application Laid-Open No. 2002-148281;
Patent Art. 10: Japanese Patent Application Laid-Open No. 50113/1995;
Patent Art. 11: Japanese Patent Application Laid-Open No. 308162/1994;
Patent Art. 12: Japanese Patent Application Laid-Open No. 2001-15565.

### DISCLOSURE OF THE INVENTION

The present invention has been made on the basis of the foregoing circumstances and has as a first object the provision of a sheet-like probe that permits forming electrode structures each having a front-surface electrode part small in diameter and surely achieving a stable electrically connected state even to a circuit device, on which electrodes have been formed at a small pitch, and prevents the electrode structures from falling off from an insulating film to achieve high durability.

A second object of the present invention is to provide a sheet-like probe that has electrode structures with high conductivity in addition to the first object.

A third object of the present invention is to provide a sheet-like probe that can impart performance characteristics required of both front-surface electrode parts and short circuit parts in the electrode structures in addition to the second object.

A fourth object of the present invention is to provide a sheet-like probe that permits surely preventing positional deviation between electrode structures and electrodes to be inspected by temperature changes in a burn-in test even when the object of inspection is a wafer having a large area of 8 inches or greater in diameter or a circuit device, the pitch of electrodes to be inspected of which is extremely small, and thus stably retaining a good electrically connected state, in addition to the above objects.

A fifth object of the present invention is to provide a process capable of producing a sheet-like probe that permits forming electrode structures each having a front-surface electrode part small in diameter and narrow in a scatter of projected height thereof and surely achieving a stable electrically connected state even to a circuit device, on which electrodes have been formed at a small pitch, prevents the electrode structures from falling off from an insulating film to achieve high durability, has electrode structures with high conductivity and can impart performance characteristics required of both front-surface electrode parts and short circuit parts in the electrode structures.

A sixth object of the present invention is to provide a process capable of producing a sheet-like probe that permits surely preventing positional deviation between electrode structures and electrodes to be inspected by temperature changes in a burn-in test even when the object of inspection is a wafer having a large area of 8 inches or greater in diameter or a circuit device, the pitch of electrodes to be inspected of which is extremely small, and thus stably retaining a good electrically connected state, in addition to the fifth object.

A seventh object of the present invention is to provide a probe card equipped with the above-described sheet-like probe.

A eighth object of the present invention is to provide an inspection apparatus for circuit devices, which is equipped with the above-described probe card.

The sheet-like probe provided by the present invention is a sheet-like probe comprising a contact film obtained by arranging, in a flexible insulating film, a plurality of electrode structures extending through in a thickness-wise direction of the insulating film in a state separated from one another in a plane direction of the insulating film, wherein
each of the electrode structures is exposed to the surfaces of the insulating film and composed of a front-surface electrode part projected from a front surface of the insulating film, a back-surface electrode part exposed to a back surface of the insulating film, a short circuit part directly joined to the front-surface electrode part and the back-surface electrode part for electrically connecting them and extending in a thickness-wise direction of the insulating film, and a holding part formed at a proximal end portion of the front-surface electrode part and extending in the plane direction of the insulating film, and wherein
at least a part of the holding part is embedded in the insulating film.

In the sheet-like probe according to the present invention, the insulating film may preferably be formed by a base layer composed of a resin and a surface layer integrally laminated on this base layer and composed of an adhesive resin or a cured product thereof.

In the sheet-like probe according to the present invention, the short circuit parts may preferably be formed by subjecting proximal ends of the front-surface electrode parts to a plating treatment.

In such a sheet-like probe, the front-surface electrode parts and the short circuit parts may be composed of different metals from each other.

The Vickers hardness (Hv) of the metal forming the front-surface electrode parts may be at least 40.

In the sheet-like probe according to the present invention, it may be preferable that the probe has a supporting film composed of a metal, in which opening has been formed, and the contact film is supported on the surface of the supporting film in such a manner that the respective electrode structures are located in the opening in the supporting film.

The supporting film may preferably have a plurality of openings.

The sheet-like probe may comprise a plurality of contact films each supported by the supporting film.

In the sheet-like probe according to the present invention, the front-surface electrode part in each electrode structure may preferably have a shape that its diameter becomes gradually small from the proximal end toward the distal end thereof.

In the sheet-like probe according to the present invention, the value of a ratio h/R₁ of the projected height h of the front-surface electrode part to the diameter R₁ of the proximal end of the front-surface electrode part in the electrode structure may preferably be 0.2 to 3.

The process provided by the present invention for producing a sheet-like probe is a process for producing the sheet-like probe described above, which comprises the steps of:
providing an electrode member-arranging plate, in which a plurality of recesses each having a shape fitted to a shape of a front-surface electrode part in each of electrode structures to be formed have been formed in a pattern corresponding to a pattern of the electrode structures, and an insulating film obtained by forming an adhesive surface layer on a base layer composed of a resin,
depositing a metal in the recesses of the electrode member-arranging plate and on peripheries thereabout, thereby forming electrode members each composed of a front-surface electrode part and a holding part extending in a plane direction of the electrode member-arranging plate from a distal end portion of the front-surface electrode part,
disposing the respective electrode members formed in the electrode member-arranging plate so as to be brought into contact with the surface layer of the insulating film and subjecting the members to a press-bonding treatment, thereby bonding the electrode members to the insulating film,
forming a plurality of through-holes each extending in a thickness-wise direction of the insulating film and linked to the front-surface electrode part in the electrode member in the insulating film, and
subjecting the front-surface electrode parts to a plating treatment to fill a metal into the through-holes in the insulating film, thereby forming short circuit parts each connected to the front-surface electrode part.

The process also provided by the present invention for producing a sheet-like probe is a process for producing the above-described sheet-like probe having the supporting film, which comprises the steps of:
providing an electrode member-arranging plate, in which a plurality of recesses each having a shape fitted to a shape of a front-surface electrode part in each of electrode structures to be formed have been formed in a pattern corresponding to a pattern of the electrode structures, and a laminate material composed of a metal film and an insulating film integrally laminated on a surface of the metal film and obtained by forming an adhesive surface layer on a base layer composed of a resin,
depositing a metal in the recesses of the electrode member-arranging plate and on peripheries thereabout, thereby forming electrode members each composed of a front-surface electrode part and a holding part extending in a plane direction of the electrode member-arranging plate from a distal end portion of the front-surface electrode part,
disposing the electrode members formed in the electrode member-arranging plate so as to be brought into contact with the surface layer of the insulating film in the laminate material and subjecting the members to a press-bonding treatment, thereby bonding the electrode members to the insulating film,
forming a plurality of through-holes each extending in a thickness-wise direction of the laminate material and linked to the front-surface electrode part in the electrode member in the laminate material,
subjecting the front-surface electrode parts to a plating treatment to fill a metal into the through-holes in the insulating film, thereby forming short circuit parts each connected to the front-surface electrode part, and
subjecting the metal film in the laminate material to an etching treatment, thereby forming a supporting film with opening formed therein.

In the processes according to the present invention for producing the sheet-like probe, each of the recesses formed in the electrode member-arranging plate may preferably have a shape that its diameter becomes gradually small from a front surface of the electrode member-arranging plate toward a back surface thereof.

The probe card provided by the present invention is a probe card for conducting electrical connection between a circuit device that is an object of inspection and a tester, which comprises:
a circuit board for inspection, on which a plurality of inspection electrodes have been formed corresponding to electrodes to be inspected of the circuit device, which is the object of inspection, an anisotropically conductive connector arranged on the circuit board for inspection, and the above-described sheet-like probe arranged on the anisotropically conductive connector.

The probe card also provided by the present invention is a probe card for conducting electrical connection between a circuit device that is an object of inspection and a tester, which comprises:
a circuit board for inspection, on which a plurality of inspection electrodes have been formed corresponding to electrodes to be inspected of the circuit device, which is the object of inspection, an anisotropically conductive connector arranged on the circuit board for inspection, and the sheet-like probe arranged on the anisotropically conductive connector and produced by the above-described process.

In the probe cards according to the present invention, it may be preferable that when the circuit device that is the object of inspection is a wafer, on which a great number of integrated circuits have been formed, the anisotropically conductive connector has a frame plate, in which a plurality of openings have been formed corresponding to electrode regions, in which electrodes to be inspected have been arranged, in the whole or part of the integrated circuits formed on the wafer, which is the object of inspection, and anisotropically conductive sheets arranged so as to close the respective openings in the frame plate.

The inspection apparatus for circuit devices provided by the present invention comprises the above-described probe card.

According to the sheet-like probes of the present invention, the holding part extending in the plane direction of the insulating film is formed at the proximal end portion of the front-surface electrode part in each of the electrode structures, so that the electrode structures are prevented from falling off from the insulating film even when the diameter of the front-surface electrode parts is small. In addition, since at least a part of the holding part is embedded in the insulating film, it is prevented from separating from the insulating film, and thus high durability is achieved.

Further, the diameter of the front-surface electrode parts formed can be made small, whereby a clearance between adjoining front-surface electrodes is sufficiently secured, and so flexibility by virtue of the insulating film can be sufficiently exhibited. As a result, a stable electrically connected state can be surely achieved even to a circuit device, on which electrodes have been formed at a small pitch.

Further, since the short circuit parts are formed by subjecting the proximal ends of the front-surface electrode parts to a plating treatment, whereby the electrode structures having high conductivity can be obtained, and the front-surface electrode parts and the short circuit parts can be formed by different materials from each other, the performance characteristics required of both front-surface electrode parts and short circuit parts can be imparted. For example, the front-surface electrode parts are formed by a metal having high hardness, whereby electrical connection can be surely achieved even to electrodes to be inspected, on which an oxide film has been formed. Alternatively, the front-surface electrode parts are formed by a material hard to be altered by solder, whereby stable conductivity can be retained over a long period of time even when the sheet-like probe is used in inspection of a circuit device having electrodes to be inspected composed of solder. On the other hand, the short circuit parts are formed by a metal having a low electric resistance value, whereby high conductivity is achieved.

Further, the supporting film for supporting the contact film is provided, whereby positional deviation between the electrode structures and electrodes to be inspected by temperature changes in a burn-in test can be surely prevented even when the object of inspection is a wafer having a large area of 8 inches or greater in diameter or a circuit device, the pitch of electrodes to be inspected of which is extremely small, and thus a good electrically connected state can be stably retained.

According to the process of the present invention for producing the sheet-like probe, the electrode members each composed of a front-surface electrode part and a holding part are formed in the recesses of the electrode member-arranging plate in advance, so that the shape and dimensions of each of the front-surface electrode parts are easily controlled, whereby the front-surface electrode parts can be provided as those small in diameter and narrow in a scatter of the projected height thereof.

In addition, the holding part is formed at the proximal end portion of each of the front-surface electrode parts, whereby the electrode structures can be formed as those prevented from falling off from the insulating film. Further, since the electrode members are bonded to the insulating film by the press-bonding treatment, the holding parts in the electrode members are held in a state that at least part thereof have been embedded in the insulating film, whereby the holding parts can be formed as those prevented from separating from the insulating film. Accordingly, sheet-like probes having high durability can be produced.

Further, since the short circuit part is formed by subjecting the proximal end of the front-surface electrode part in each of the electrode members bonded to the insulating film to a plating treatment, the front-surface electrode part and the short circuit part can be formed integrally with each other, whereby a good electrically connected state is achieved between both parts. As a result, electrode structures having high conductivity can be formed. Further, since the front-surface electrode parts and the short circuit parts can be formed by different materials from each other, the performance characteristics required of both front-surface electrode parts and short circuit parts can be imparted.

Further, since the laminate material obtained by laminating an insulating film on the surface of a metal film is used, and the supporting film composed of a metal for supporting the insulating film can be formed by subjecting the metal film of the laminate material to an etching treatment, positional deviation between the electrode structures and electrodes to be inspected by temperature changes in a burn-in test can be surely prevented even when the object of inspection is a wafer having a large area of 8 inches or greater in diameter or a circuit device, the pitch of electrodes to be inspected of which is extremely small, and thus sheet-like probes capable of stably retaining a good electrically connected state can be produced.

According to the probe card of the present invention, the above-described sheet-like probe is installed therein, and the electrode structures having the front-surface electrode part small in diameter can be formed, so that a stable electrically connected state can be surely achieved even to a circuit device, on which electrodes have been formed at a small pitch. In addition, the electrode structures are prevented from falling off from the insulating film, and thus high durability is achieved.

According to the inspection apparatus for circuit devices of the present invention, the above-described probe is installed therein, so that a stable electrically connected state can be surely achieved even to a circuit device, on which electrodes have been formed at a small pitch. In addition, inspection can be performed with high reliability over a long period of time even when the inspection is conducted as to a great number of circuit devices.

### BRIEF DESCRIPTION OF THE DRAWINGS

Fig. 1 is a plan view illustrating a sheet-like probe according to a first embodiment of the present invention.
Fig. 2 is a plan view illustrating, on an enlarged scale, a part of a contact film in the sheet-like probe according to the first embodiment.
Fig. 3 is a cross-sectional view illustrating, on an enlarged scale, a part of the contact film in the sheet-like probe according to the first embodiment.
Fig. 4 is a cross-sectional view illustrating the construction of an electrode member-arranging plate used for producing the sheet-like probe according to the first embodiment.
Fig. 5 is a cross-sectional view illustrating an arranging plate-forming material with protecting films formed on both surfaces thereof.
Fig. 6 is a cross-sectional view illustrating a state that resist films have been formed on the protecting films of the arranging plate-forming material.
Fig. 7 is a cross-sectional view illustrating a state that patterned holes have been formed in the resist film on the protecting film of the arranging plate-forming material.
Fig. 8 is a cross-sectional view illustrating a state that patterned holes have been formed in the protecting film of the arranging plate-forming material.
Fig. 9 is a cross-sectional view illustrating a state that the resist films have been removed from the protecting films of the arranging plate-forming material.
Fig. 10 is a cross-sectional view illustrating a state that a resist film has been formed on the protecting film of the electrode member-arranging plate.
Fig. 11 is a cross-sectional view illustrating a state that metal layers have been formed on inner surfaces of recesses of the electrode member-arranging plate and on the resist film.
Fig. 12 is a cross-sectional view illustrating a state that resist films have been formed on the metal layers formed on the electrode member-arranging plate.
Fig. 13 is a cross-sectional view illustrating a state that electrode members have been formed in the recesses of the electrode member-arranging plate.
Fig. 14 is a cross-sectional view illustrating a state that the resist films and the metal layers have been removed from the electrode member-arranging plate.
Fig. 15 is a cross-sectional view illustrating the construction of a laminate material used for producing the sheet-like probe according to the first embodiment.
Fig. 16 is a cross-sectional view illustrating a state that electrode members have been press-bonded to an insulating film in the laminate material.
Fig. 17 is a cross-sectional view illustrating a state that a resist film for etching having patterned holes has been formed on a back surface of a metal film in the laminate material.
Fig. 18 is a cross-sectional view illustrating a state that through-holes have been formed in the metal film in the laminate material.
Fig. 19 is a cross-sectional view illustrating a state that through-holes have been formed in the insulating film in the laminate material.
Fig. 20 is a cross-sectional view illustrating a state that a resist film for plating having patterned holes has been formed on the metal film in the laminate material.
Fig. 21 is a cross-sectional view illustrating a state that short circuit parts and back-surface electrode parts have been formed at proximal ends of front-surface electrode parts.
Fig. 22 is a cross-sectional view illustrating a state that the resist film has been removed from the back surface of the metal film in the laminate material.
Fig. 23 is a cross-sectional view illustrating a state that a resist film for etching has been formed on the back surface of the metal film in the laminate material.
Fig. 24 is a cross-sectional view illustrating a state that a part of the metal film has been removed to form a plurality of back-surface electrode parts separated from one another and at the same time form a supporting film.
Fig. 25 is a plan view illustrating a sheet-like probe according to a second embodiment of the present invention.
Fig. 26 is a plan view illustrating, on an enlarged scale, a part of a contact film in the sheet-like probe according to the second embodiment.
Fig. 27 is a cross-sectional view illustrating, on an enlarged scale, a part of the contact film in the sheet-like probe according to the second embodiment.
Fig. 28 is a cross-sectional view illustrating a state that resist films have been formed so as to cover a front surface of a part of an insulating film, front-surface electrode parts and holding parts, and a resist film has been formed so as to cover a back surface of a supporting film, a back surface of the insulating film and back-surface electrode parts.
Fig. 29 is a cross-sectional view illustrating a state that a part of the insulating film has been removed to form a plurality of divided insulating films.
Fig. 30 is a plan view illustrating a sheet-like probe according to a third embodiment of the present invention.
Fig. 31 is a plan view illustrating, on an enlarged scale, a part of a contact film in the sheet-like probe according to the third embodiment.
Fig. 32 is a cross-sectional view illustrating, on an enlarged scale, a part of the contact film in the sheet-like probe according to the third embodiment.
Fig. 33 is a cross-sectional view illustrating a state that a resist film has been formed so as to cover a front surface of a part of an insulating film, front-surface electrode parts and holding parts, and a resist film has been formed so as to cover a back surface of a supporting film, a back surface of the insulating film and back-surface electrode parts.
Fig. 34 is a cross-sectional view illustrating a state that a part of the insulating film has been removed to form a plurality of divided insulating films.
Fig. 35 is a cross-sectional view illustrating the construction of an exemplary inspection apparatus for circuit devices according to the present invention.
Fig. 36 is a cross-sectional view illustrating, on an enlarged scale, a probe card in the inspection apparatus shown in Fig. 35.
Fig. 37 is a plan view of an anisotropically conductive connector in the probe card.
Fig. 38 is a plan view illustrating a sheet-like probe according to a further embodiment of the present invention.
Fig. 39 is a cross-sectional view illustrating the construction of an exemplary conventional probe card.
Fig. 40 is a cross-sectional view illustrating a production process of a conventional sheet-like probe.
Fig. 41 is a cross-sectional view illustrating, on an enlarged scale, a sheet-like probe in the probe card shown in Fig. 39.
Fig. 42 is a cross-sectional view illustrating another production example of a conventional sheet-like probe.
Fig. 43 is a cross-sectional view illustrating a further production example of a conventional sheet-like probe.
Fig. 44 is a plan view illustrating a wafer for test fabricated in Example.
Fig. 45 illustrates a position of a region of electrodes to be inspected of an integrated circuit formed on the wafer for test.
Fig. 46 is a plan view illustrating the region of the electrodes to be inspected of the integrated circuit formed on the wafer for test.
Fig. 47 is a cross-sectional view illustrating, on an enlarged scale, a part of the region of the electrodes to be inspected of the integrated circuit formed on the wafer for test.
Fig. 48 is a cross-sectional view illustrating a production process of a sheet-like probe in Comparative Example 2.

### [Description of Characters]

1 Probe card,
2 Guide pins,
3 Pressurizing plate,
4 Wafer-mounting table,
5 Heater,
6 Wafer,'
7 Electrodes to be inspected,
8 Insulating layer,
10 Sheet-like probe,
10A Laminate material,
11 Supporting film,
11A Metal film,
11H Openings,
11K Positioning holes,
12, 12a, 12b Contact films,
13, 13a, 13b Insulating films,
13K Base layer,
13M Thin metal layer,
13S Surface layer,
13H Through-holes,
14A, 14B, 14C, 14D, 14E, 14F, 14G Resist films,
15 Electrode structures,
16 Front-surface electrode parts,
16A Electrode members,
17 Back-surface electrode parts,
17H Through-holes,
18 Short circuit parts,
19 Holding parts,
20 Circuit board for inspection,
21 Inspection electrodes,
30 Anisotropically conductive connector,
31 Frame plate,
32 Openings,
33 Air inflow holes,
35 Anisotropically conductive sheet,
36 Conductive parts,
37 Insulating parts,
38 Projected portions,
40 Electrode member-arranging plate,
40A Arranging plate-forming material,
40B Intermediate composite material,
41 Recesses,
42, 43 Protecting films
42K Patterned holes,
45, 46, 47, 48 Resist films
45K, 47k, 48K Patterned holes,
50 Metal layer,
60 Holding member,
70A Laminate material,
70K Recesses for forming electrode structures,
71 Insulating film,
75 Electrode structures,
76 Front-surface electrode parts,
76A Second front surface-side metal layer,
76B Insulating layer,
77 Back-surface electrode parts,
77A Back surface-side metal layer,
78 Short circuit parts,
79 Holding parts,
79A First front surface-side metal layer,
80 Anisotropically conductive sheet,
85 Circuit board for inspection,
86 Inspection electrodes,
90 Sheet-like probe,
90A, 90B, 90C Laminate materials,
90K Recesses for forming electrode structures,
91 Insulating film,
91A Insulating film material,
92, 92A, 92B Metal Layers,
93, 93A Resist films,
94A, 94B Resist films,
95 Electrode structures,
96 Front-surface electrode parts,
97 Back-surface electrode parts,
98 Short circuit parts,
98H Through-holes,
A Region of electrodes to be inspected,
K1, K2 Patterned holes,
L Integrated circuits,
P Conductive particles.

### BEST MODE FOR CARRYING OUT THE INVENTION

The embodiments of the present invention will hereinafter be described in details.

### [Sheet-like probe]

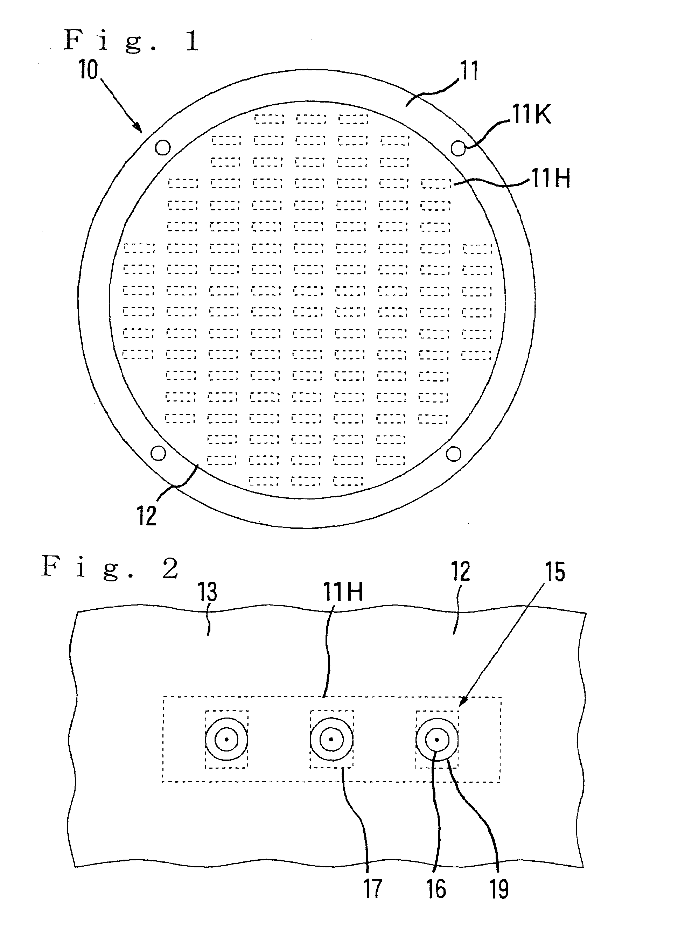

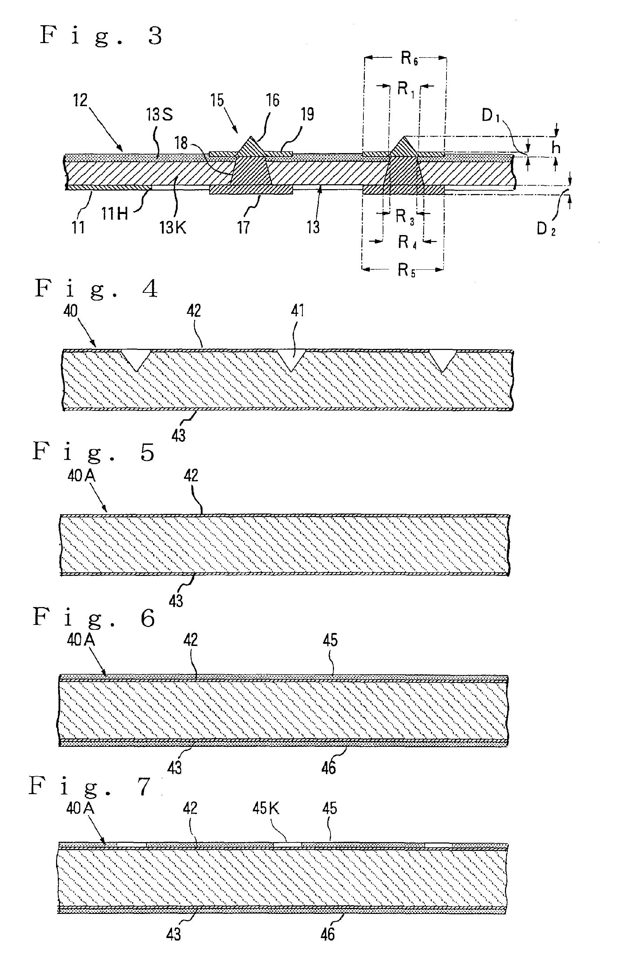

Fig. 1 is a plan view of a sheet-like probe according to a first embodiment of the present invention illustrating a part thereof by broken lines, Fig. 2 is a plan view illustrating, on an enlarged scale, a contact film of the sheet-like probe according to the first embodiment, and Fig. 3 is a cross-sectional view illustrating, on an enlarged scale, the contact film of the sheet-like probe according to the first embodiment.

The sheet-like probe 10 according to the first embodiment is used in conducting electrical inspection of, for example, a wafer, on which a plurality of integrated circuits have been formed, as to each of the integrated circuits in a state of the wafer, and has a supporting film 11 composed of a metal, in which a plurality of openings 11H have been formed. The openings 11H in this supporting film 11 are formed corresponding to a pattern of an electrode region, in which electrodes to be inspected have been formed, of an integrated circuit in a wafer, which is an object of inspection. In the supporting film 11 in this embodiment, positioning holes 11K for conducting positioning to an anisotropically conductive connector and a circuit board for inspection in a probe card, which will be described subsequently, are formed.

As a metal for forming the supporting film 11, may be used iron, copper, nickel, titanium or an alloy or alloy steel thereof. However, an iron-nickel alloy steel such as 42 alloy, invar or covar is preferred in that the openings 11H can be easily formed by an etching treatment in a production process which will be described subsequently.

As the supporting film 11, is preferably used a material having a coefficient of linear thermal expansion of at most 3 x 10⁻⁵/K, more preferably -1 x 10⁻⁷ to 1 x 10⁻⁵/K, particularly preferably -1 x 10⁻⁶ to 8 x 10⁻⁶/K.

Specific examples of such a material for forming the supporting film 11 include invar alloys such as invar, Elinvar alloys such as Elinvar, and alloys or alloy steels such as superinvar, covar and 42 alloy.

The thickness of the supporting film 11 is preferably, 3 to 100 µm, more preferably 5 to 50 µm.

If this thickness is smaller than 3 µm, the strength required of the supporting film for supporting a contact film 12 may not be achieved in some cases. If this thickness exceeds 100 µm on the other hand, it may be difficult in some cases to easily form the openings 11H by an etching treatment in the production process which will be described subsequently.

On a front surface (upper surface in Fig. 3) of this supporting film 11, a circular single contact film 12 having a diameter smaller than the diameter of the supporting film 11 is provided integrally with the supporting film 11 and supported thereby.

This contact film 12 has a flexible insulating film 13. In this insulating film 13, a plurality of electrode structures 15 each extending in a thickness-wise direction of the insulating film 13 are arranged in relation separated from each other in a plane direction of the insulating film 13 in accordance with a pattern corresponding to a pattern of electrodes to be inspected in all integrated circuits formed on a wafer that is an object of inspection. This contact film 12 is arranged in such a manner that the electrode structures 15 are located in the respective openings 11H of the supporting film 11.

Each of the electrode structures 15 is composed of a projected front-surface electrode part 16 exposed to a front surfaces of the insulating film 13 and protruding from the front surface of the insulating film 13, a rectangular flat plate-like back-surface electrode part 17 exposed to a back surface of the insulating film 13, a short circuit part 18 extending from the proximal end of the front-surface electrode part 16 through in the thickness-wise direction of the insulating film 13 and linked to the back-surface electrode part 17, and a circular ring plate-like holding part 19 continuously extending from a peripheral surface of a proximal end portion of the front-surface electrode part 16 radially in a plane direction of the insulating film 13. A part of the holding part 19 is embedded in the insulating film 13. In the electrode structures 15 of this embodiment, each front-surface electrode part 16 is formed continuously with the short circuit part 18 in a tapered shape that the diameter becomes gradually small as it goes toward a distal end from a proximal end thereof, i.e., formed in a conical shape as a whole, and the short circuit part 18 continuous with the proximal end of the front-surface electrode part 16 is formed in a tapered shape that the diameter becomes gradually small as it goes toward the front surface from the back surface of the insulating film 13, i.e., formed in a truncated cone shape as a whole. The short circuit part 18 is formed continuously integrally with the front-surface electrode part 16 by subjecting the proximal end of the front-surface electrode part 16 to a plating treatment.

The insulating film 13 is formed from a base layer 13K composed of a resin and a surface layer 13S laminated on this base layer integrally and composed of an adhesive resin or a cured product thereof.

No particular limitation is imposed on the resin forming the base layer 13K in the insulating film 13 so far as it has insulating property and is flexible. For example, a polyamide resin, a liquid crystal polymer, polyester, a fluororesin or a sheet obtained by impregnating a cloth woven by fibers with any of the above-described resins may be used. However, the base layer is preferably composed of a material capable of being etched in that through-holes for forming the short circuit parts 18 can be easily formed by etching, and particularly preferably composed of a polyimide resin.

As the adhesive resin forming the surface layer 13S in the insulating film 13, may be used a thermosetting resin, a thermoplastic resin, a radiation-curable resin or the like. Specific examples thereof include epoxy resins, phenoxy resins, urethane resins, polystyrene resins, polyethylene resins, polyester resins, polyamide resins, polyimide resins, polycarbonate resins and silicone resins.

Among these, thermoplastic polyimide resins are preferred in that excellent heat resistance and durability can be obtained and through-holes for forming the short circuit parts 18 can be easily formed by etching.

The thickness of the surface layer 13S in the insulating film 13 is preferably 3 to 30 µm, more preferably 5 to 20 µm.

No particular limitation is imposed on the thickness of the insulating film 13 so far as the insulating film 11 is flexible. However, it is preferably 10 to 50 µm, more preferably 10 to 25 µm.

A metal used in forming the front-surface electrode parts 16 in the electrode structures 15 may be selected for use from various kinds of metals according to the performance characteristics required of the front-surface electrode parts 16. For example, when the front-surface electrode parts 16 are required to have a high hardness, a high-hardness metal having a Vickers hardness (Hv) of preferably at least 40, more preferably at least 150, still more preferably at least 300, particularly preferably at least 500 may be used. When the front-surface electrode parts 16 are formed by a laminate material composed of 2 or more layers, it is only necessary to make a metal forming an outermost layer to have a hardness as high as at least 40, preferably at least 150, more preferably at least 300, particularly preferably at least 500 in terms of Vickers hardness.

When the front-surface electrode parts 16 are formed by the metal having a high hardness, they may be formed of a single metal, or two or more metals. When they are formed by 2 or more metals, it is not necessary to use only metals having a Vickers hardness (Hv) of at least 40. As long as a Vickers hardness of at least 40 is secured, however, such a material may be composed of an alloy of a metal having a Vickers hardness of at least 40 and any other metal than it, for example, gold, and the material may also have a phase-separation structure that a metal phase composed of the metal having a Vickers hardness of at least 40 is dispersed in a metal phase composed of any other metal than it, for example, gold.

As the high-hardness metal, may be used palladium, rhodium, ruthenium, iridium, platinum, tungsten, nickel, cobalt, chromium or an alloy thereof. Among these, palladium, rhodium, ruthenium, iridium, platinum and nickel may preferably be used in that they are chemically stable and have a high electric conductivity.

As the alloy of the metal having a Vickers hardness (Hv) of at least 40 and gold, may be used a gold-palladium alloy, a gold-copper alloy, a platinum·gold alloy, hard gold containing 0.1 to 1.0% of nickel or cobalt, a phosphorus·nickel alloy, or the like.

As a metal forming the short circuit parts 18 and the back-surface electrode parts 17 in the electrode structures 15, may be used a metal having a low electric resistance value, for example, nickel, copper, gold, silver, palladium or iron.

On the surfaces of the back-surface electrode part 17, a film of a chemically stable metal having high conductivity, such as gold, silver or palladium, may be formed in order that oxidation of the electrode parts may be prevented, and electrode parts small in contact resistance may be provided.

The holding parts 19 in the electrode structures 15 may be formed with any of various metals.

As described above, the front-surface electrode parts 16, back-surface electrode parts 17, short circuit parts 18 and holding parts 19 in the electrode structures 15 may be formed by metals different from one another, but may also be formed by the same metal.

When the front-surface electrode parts 16, back-surface electrode parts 17, short circuit parts 18 and holding parts 19 are formed by the same metal, the metal is preferably selected in view of the performance characteristics required of the front-surface electrode parts 16. For example, a high-conductive metal having a Vickers hardness (Hv) of at least 40 is preferably used.

The diameter R₁ of the proximal end of the front-surface electrode part 16 in each of the electrode structures 15 is preferably 30 to 70%, more preferably 35 to 60% of the pitch of the electrode structures 15.

A ratio h/R₁ of the projected height h of the front-surface electrode part 16 to the diameter R₁ of the proximal end thereof is preferably 0.2 to 3, more preferably 0.25 to 0.6. Even when a wafer that is an object of inspection has minute electrodes to be inspected at a small pitch, electrode structures 15 of a pattern corresponding to a pattern of electrodes to be inspected can be easily formed by satisfying such conditions, and moreover a stable electrically connected state to the wafer is more surely achieved.

The diameter R₁ of the proximal end of the front-surface electrode part 16 is preset in view of the above-described conditions, the diameter of its corresponding electrode to be inspected of the wafer that is the object of inspection, and the like. However, it is, for example, preferably 30 to 80 µm, more preferably 30 to 50 µm.

The projected height h of the front-surface electrode part 16 is preferably 15 to 50 µm, more preferably 15 to 30 µm in that stable electrical connection to its corresponding electrode to be inspected of the wafer that is the object of inspection can be achieved.

The outer diameter R₅ of each back-surface electrode part 17 is only required to be greater than the diameter R₄ of the other end of the short circuit part 18 linked to the back-surface electrode part 17 and smaller than the pitch of the electrode structures 15 and is preferably great as much as possible. Stable electrical connection can be thereby achieved with certainty even to, for example, an anisotropically conductive sheet.

The thickness D₂ of the back-surface electrode part 17 is preferably 10 to 40 µm, more preferably 15 to 35 µm in that sufficiently high strength and excellent repetitive durability are achieved.

A ratio R₃/R₄ of the diameter R₃ of one end of the short circuit part 18 to the diameter R₄ of the other end thereof is preferably 0.45 to 1, more preferably 0.7 to 0.9.

The diameter R₃ of one end of the short circuit part 18 is preferably 30 to 70%, more preferably 35 to 60% of the pitch of the electrode structures 15.

The diameter R₆ of each holding part 19 is preferably 30 to 70%, more preferably 40 to 60% of the pitch of the electrode structures 15.

The thickness D₁ of the holding part 19 is preferably 3 to 12 µm, more preferably 5 to 9 µm.

According to such a sheet-like probe 10 according to the first embodiment, the holding part 19 extending in a plane direction of the insulating film 13 is formed at the proximal end portion of the front-surface electrode part 16 in each of the electrode structures 15, so that the electrode structures 16 are prevented from falling off from the insulating film 13 even when the diameter of the front-surface electrode part 16 is small. In addition, since a part of the holding part 19 is embedded in the insulating film 13, it is prevented from separating from the insulating part 13. Accordingly, high durability is achieved.

In addition, the front-surface electrode parts 16 small in diameter can be formed, whereby a clearance between adjoining front-surface electrode parts 16 can be sufficiently secured, and so flexibility by virtue of the insulating film 13 can be sufficiently exhibited. As a result, a stable electrically connected state can be surely achieved even to a circuit device, on which electrodes have been formed at a small pitch.

Further, since the short circuit parts 18 are formed integrally and continuously with the respective front-surface electrode parts 16 by subjecting the proximal ends of the front-surface electrode parts 16 to a plating treatment, whereby the electrode structures can be provided as those having high conductivity, and moreover the front-surface electrode parts 16 and the short circuit parts 18 can be formed by different materials from each other, the performance characteristics required of both front-surface electrode parts 16 and short circuit parts 18 can be imparted. For example, the front-surface electrode parts 18 are formed by a metal having a high hardness, whereby electrical connection can surly be achieved even to the electrodes to be inspected on which an oxide film have been formed. Further, the front-surface electrode parts 16 are formed by a material hard to be altered by solder, whereby stable conductivity can be retained over a long period of time even when the sheet-like probe is used in inspection of a circuit device having electrodes to be inspected composed of solder. On the other hand, the short circuit parts 18 are formed by a metal having a low electric resistance value, whereby high conductivity is achieved.

Further, since a plurality of the openings 11H are formed in the supporting film 11 correspondingly to electrode regions, in which electrodes to be inspected have been formed, of a wafer that is an object of inspection and the contact film 12 is disposed on the supporting film 11 in such a manner that the respective electrode structures 15 are located in their corresponding openings 11H in the supporting film 11, whereby the contact film 12 is supported by the supporting film 11 over the whole surface thereof, the thermal expansion of the insulating film 13 in the plane direction thereof can be surely suppressed by the supporting film 11 even when the contact film 12 has a large area. Accordingly, positional deviation between the electrode structures 15 and electrodes to be inspected by temperature changes in a burn-in test can be surely prevented even when the object of inspection is a wafer having a large area of, for example, 8 inches or greater in diameter, and the pitch of electrodes to be inspected is extremely small. As a result, a good electrically connected state to the wafer can be stably retained.

The sheet-like probe 10 according to the first embodiment can be produced, for example, in the following manner.

In this process, such an electrode member-arranging plate 40 as shown in Fig. 4 is used. The electrode member-arranging plate 40 in this embodiment is composed of a material capable of being anisotropically etched, and recesses 41 are formed in one surface (upper surface in Fig. 4) thereof in accordance with a pattern corresponding to a pattern of front-surface electrode parts 16 in a sheet-like probe 10 to be produced. The recesses 41 are formed by anisotropic etching, and the shape of each recess 41 is a shape fitted to the shape of the front-surface electrode part 16, i.e., a conical shape that the diameter becomes gradually small as it goes toward the other surface from one surface of the electrode member-arranging plate 40. In this embodiment, protecting films 42 and 43 are formed on other regions than the recesses 41 in one surface of the electrode member-arranging plate 40 and the other surface of the electrode member-arranging plate 40, respectively. The protecting films 42, 43 are utilized as resists for forming the recesses 41 by anisotropic etching.

No particular limitation is imposed on a material forming the electrode member-arranging plate 40 so far as it can be anisotropically etched, and, for example, monocrystal silicon, germanium or the like may be used. However, monocrystal silicon is preferably used in that recesses 41 having expected dimensional accuracy can be surely obtained by anisotropic etching, and high durability is achieved. That having high purity is more preferably used in that recesses 41 having still higher dimensional accuracy can be obtained by anisotropic etching, and a surface having high surface precision is provided. In particular, that obtained by processing a silicon wafer having a crystal face (1,0,0) as a surface is preferably used as the electrode member-arranging plate 40. The thickness (thickness of other portions than portions where the recesses 41 have been formed) of the electrode member-arranging plate 40 is, for example, 0.2 to 1 mm, preferably 0.25 to 0.6 mm. The depth of each recess 41 is suitably preset according to the height of front-surface electrode parts 16 to be formed. As a material for forming the protecting films 42, 43, may be used silicon dioxide (SiO₂), silicon nitride (Si₃N₄), chromium (Cr), gold (Au) or the like. However, silicon dioxide (SiO₂) is preferably used in that it is the easiest to use.

This electrode member-arranging plate 40 can be produced, for example, in the following manner.

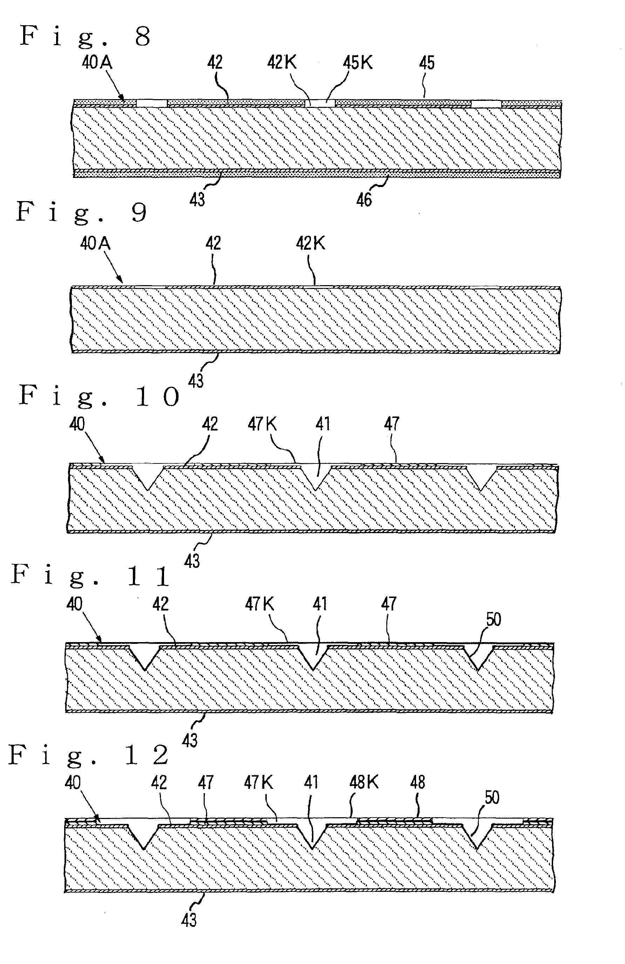

As illustrated in Fig. 5, a plate-like arranging plate-forming material 40A composed of monocrystal silicon and having a crystal face (1,0,0) as a surface, on both surfaces of which protecting films 42 and 43 formed of silicon dioxide have been formed, is first provided. As illustrated in Fig. 6, resist films 45 and 46 for subjecting the protecting films 42, 43 to an etching treatment are formed on respective surfaces of the protecting films 42, 43 formed on both surfaces of the arranging plate-forming material 40A by lithographic technique.

Thereafter, a plurality of patterned holes 45K are formed in the resist film 45 formed on one surface (upper surface in Fig. 7) side of the arranging plate-forming material 40A correspondingly to recesses 41 to be formed as illustrated in Fig. 7.

As illustrated in Fig. 8, the protecting film 42 formed on one surface of the arranging plate-forming material 40A is then subjected to an etching treatment through the patterned holes 45K in the resist film 45, thereby forming patterned holes 42K linked to the respective patterned holes 45K of the resist film 45 in the protecting film 42. After the resist films 45, 46 are then removed as illustrated in Fig. 9, one surface of the arranging plate-forming material 40A is subjected to an anisotropic etching treatment through the patterned holes 42K of the protecting film 42 using the protecting films 42, 43 as resists, thereby forming conical recesses 41, thus obtaining the surface electrode member-arranging plate 40 shown in Fig. 4.

In the above-described process, a silicon wafer having a crystal face (1,0,0) as a surface is preferably used as the arranging plate-forming material 40A in an intact state or a state that it has been processed into a proper shape. As an etchant used in the etching treatment for the protecting film 42, may be used hydrofluoric acid or the like. As etchant used in the anisotropic etching treatment for the arranging plate-forming material 40A, may be used an aqueous solution of potassium hydroxide, ethylenediamine or the like. Conditions for the anisotropic etching treatment of the arranging plate-forming material 40A, for example, a treating temperature and treating time, are suitably preset according to the kind of the etchant, the depth of recesses 41 for forming front-surface electrode members, which are to be formed, and the like. For example, the treating temperature is 60 to 85°C.

The sheet-like probe is produced in the following manner using the electrode member-arranging plate 40 of such construction as described above.

As illustrated in Fig. 10, a resist film 47 having patterned holes 47K of a pattern corresponding to holding parts 19 to be formed is first formed on other regions than the recesses 41 in one surface of the electrode member-arranging plate 40. Thereafter, the surface of the resist film 47 and regions exposed through the patterned holes 47K of the resist film 47 in one surface of the electrode member-arranging plate 40 are subjected to a plating treatment, a sputtering treatment or a vapor deposition treatment, whereby a metal layer 50 is formed as illustrated in Fig. 11. As illustrated in Fig. 12, a resist film 48 having patterned holes 48K linked to the respective patterned holes 47K of the resist film 47 at portions located on the resist film 47 in the metal layer 50 is formed.

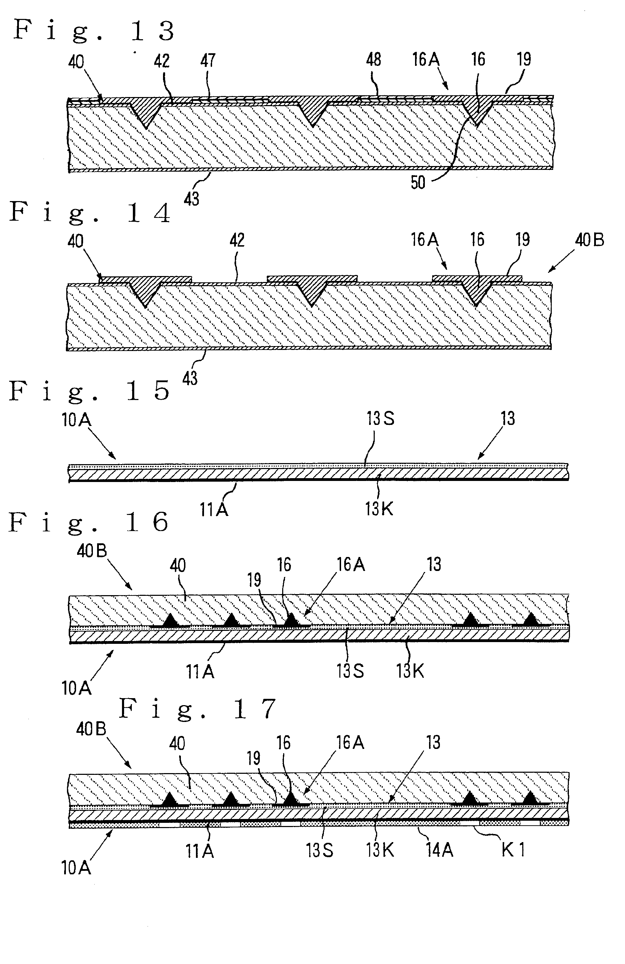

A metal is deposit in the respective recesses 41 of the electrode member-arranging plate 40 and on peripheries thereabout, i.e., the patterned holes 47K and 48K of the resist films 47 and 48, thereby forming electrode members 16A each composed of a front-surface electrode part 16 and a holding part 19 extending in a plane direction of the electrode member-arranging plate 40 from a distal end portion of the front-surface electrode part 16 as illustrated in Fig. 13.

In the above-described process, as a method for depositing the metal in the respective recesses 41 of the electrode member-arranging plate 40 and on the peripheries thereabout, may be used an electroplating treatment using the metal layer 50 as a common electrode, a chemical plating treatment, a sputtering treatment, a vapor deposition treatment or the like. However, the electroplating treatment and chemical plating treatment are preferred, with the electroplating treatment being more preferred.

The resist film 48, the metal layer 50 and resist film 47 are then removed from one surface of the electrode member-arranging plate 40, thereby obtaining an intermediate composite material 40B, in which a plurality of electrode members 16A have been arranged on the electrode member-arranging plate 40 in accordance with a pattern corresponding a pattern of electrode structures 15 to be formed as illustrated in Fig. 14.

On the other hand, as illustrated in Fig. 15, a laminate material 10A having a circular metal film 11A and an insulating film 13 integrally laminated on a surface of this metal layer 11A and obtained by integrally laminating a surface layer 13S composed of an adhesive resin on a base layer 13K composed of a resin is provided.

In this laminate material 10A, the metal film 11A serves to form a supporting film 11 to be formed, is composed of the same material as the supporting film 11 and has a thickness equivalent to the thickness of the supporting film 11.

As the resin for forming the base layer 13K in the insulating film 13, is preferably used a polymeric material capable of being etched, with a polyimide resin being more preferred.

As the adhesive resin for forming the surface layer 13S in the insulating film 13, is preferably used a polymeric material capable of being etched, with a thermoplastic polyimide resin being more preferred.

Such a laminate material 10A can be obtained by a process comprising providing a laminated polyimide sheet, on one surface of which a metal layer composed of, for example, 42 alloy has been laminated, and a thermoplastic polyimide sheet, arranging the thermoplastic polyimide resin on the resin surface in the laminated polyimide sheet and subjecting both sheets to a heating and press-bonding treatment, a process comprising coating the resin surface in the above-described laminated polyimide sheet with a varnish with, for example, polyimide dissolved therein and subjecting the coated sheet to a drying treatment, or the like.

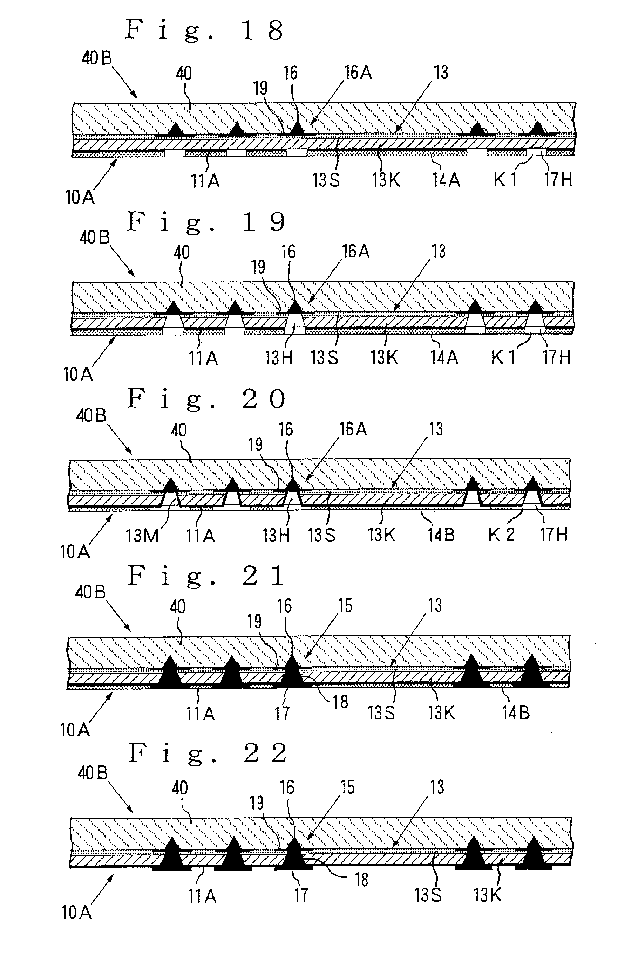

As illustrated in Fig. 16, the intermediate composite material 40B is arranged on the surface layer 13S in such a laminate material 10A so as to bring the respective electrode members 16A into contact with the surface layer to conduct a heating and press-bonding treatment, thereby bonding the respective electrode members 16A to the insulating film 13. At this time, at least part of the holding part 19 in each of the electrode members 16A and a proximal end portion where the holding part 19 has been formed are held in a state embedded in the surface layer 13S by a pressure by the heating and press-bonding treatment.

A resist film 14A with a plurality of patterned holes K1 formed in accordance with a pattern corresponding to a pattern of electrode structures 15 to be formed is then formed on a back surface of the metal film 11A in the laminate material 10A as illustrated in Fig. 17, and portions exposed through the patterned holes K1 of the resist film 14A in the metal film 11A are subjected to an etching treatment to remove these portions, thereby forming, in the metal film 11A, a plurality of through-holes 17H linked to the respective patterned holes K1 of the resist film 14A as illustrated in Fig. 18. Thereafter, portions exposed through the respective patterned holes K1 of the resist film 14A and the respective through-holes 17H of the metal film 11A in the insulating film 13 are subjected to an etching treatment to remove these portions, thereby forming, in the insulating film 13, a plurality of tapered through-holes 13H, the diameter of which becomes gradually small from the back surface of the insulating film 13 toward the front surface thereof, and which are linked to the respective through-holes 17H of the metal film 11A as illustrated in Fig. 19, thus forming, in the laminate material 10A, a plurality of through-holes (17H and 13H) each extending in a thickness-wise direction of the laminate material and linked to the front-surface electrode part 16 in the electrode member 16A.

In the above-described process, an etchant for etching the metal film 11A is suitably selected according to a material forming the metal layer. For example, an aqueous solution of ferric chloride may be used.

As an etchant for etching treatment of the insulating film 13, an aqueous hydrazine solution, an aqueous solution of potassium hydroxide or the like may be used when the insulating film 13 is composed of, for example, polyimide. The tapered through-holes 131H, the diameter of which becomes gradually small from the back surface toward the front surface, can be formed in the insulating sheet 13 by selecting conditions for the etching treatment.

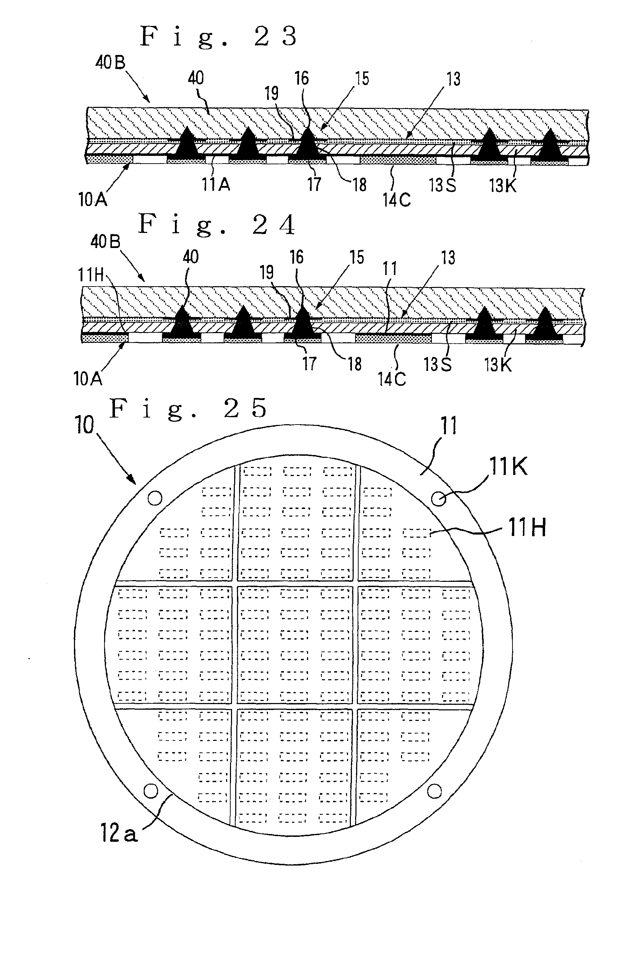

After the resist film 14A is removed from the laminate material 10A, in which the through-holes (17H and 13H) have been formed in such a manner, a thin metal layer 13M is formed on an inner wall surface of each of the through-holes 13H in the laminate material 10A by, for example, sputtering, and a resist film 14B, in which a plurality of patterned holes K2 have been formed in accordance with a pattern corresponding to a pattern of back-surface electrode parts 17 in electrode structures 15 to be formed, is formed on a back surface of the metal film 11A in the laminate material 10A as illustrated in Fig. 20. Here, the metal film 11A and the electrode members 16A lie in a state linked to each other through the thin metal layers 13M.

Proximal end surfaces of the front-surface electrode parts 16 in the electrode members 16A, the thin metal layers 13M and exposed portions of the metal layer 11A are then subjected to an electroplating treatment by using the metal film 11A as a common electrode to fill a metal into the through-holes 13H of the insulating film 13, the openings 11H of the metal film 11A and the patterned holes K2 of the resist film 14B, thereby forming short circuit parts 18 continuously extending from the respective proximal ends of the front-surface electrode parts 16 through in a thickness-wise direction of the insulating film 11, and back-surface electrode parts 17 respectively linked to the other ends of the short circuit parts 18 as illustrated in Fig. 21. Here, the back-surface electrode parts 17 lie in a state connected to one another through the metal film 11A.

After the resist film 14B is removed from the laminate material 10A, in which the short circuit parts 18 and back-surface electrode parts 17 have been formed in such a manner, thereby exposing the back surface of the metal layer 11A as illustrated in Fig. 22, a patterned resist film 14C is formed so as to cover the back-surface electrode parts 17 and a portion, which will become a supporting film 11, in the metal film as illustrated in Fig. 23. Exposed portions in the metal film 11A are subjected to an etching treatment, thereby removing the exposed portions in the metal film 11A, whereby a plurality of back-surface electrode parts 17 separated from one another are formed, and a supporting film 11 having a plurality of openings 11H corresponding to electrode regions of integrated circuits formed on a wafer that is an object of inspection is formed as illustrated in Fig. 24.

The resist film 14C is then removed, and moreover the electrode member-arranging plate 40 is removed, thereby obtaining the sheet-like probe 10 shown in Figs. 1 to 3.

According to such a process, the electrode members 16A each composed of the front-surface electrode part 16 and the holding part 19 are formed in the recesses 41 in the electrode member-arranging plate 40 in advance, so that the shape and dimensions of each front-surface electrode part 16 are easily controlled, whereby the front-surface electrode parts 16 can be provided as those small in diameter and narrow in a scatter of the projected height thereof.

In addition, the holding parts 19 each continuously extending from the proximal end portion of the front-surface electrode part 16 outward along the front surface of the insulating sheet 11 can be surely formed by subjecting the front surface-side metal layer 19A formed on the front surface of the insulating sheet 11 to an etching treatment, so that the sheet-like connector 10 that prevents the electrode structures 15 from falling off from the insulating sheet 11 to achieve high durability can be produced even when the diameter of the front-surface electrode parts 16 is small.

In addition, the holding part 19 is formed at the proximal end portion of each of the front-surface electrode parts 16, so that the electrode structures 15 can be provided as those prevented from falling off from the insulating film 13. Further, since the electrode members 16A are bonded to the insulating film 13 by a heating and press-bonding treatment, at least a part of the holding part 19 in each of the electrode members 16A is embedded in the insulating film 13, whereby the holding parts 19 can be formed as those prevented from separating from the insulating film 13. Accordingly, a sheet-like probe 10 having high durability can be produced.

Further, since the short circuit parts 18 are formed by subjecting the proximal ends of the front-surface electrode parts 16 in the electrode members 16A bonded to the insulating film 13 to a plating treatment, the front-surface electrode part 16 and the short circuit part 18 are formed integrally with each other, whereby a good electrically connected state is achieved between both parts. As a result, electrode structures 15 having high conductivity can be formed. Further, since the front-surface electrode parts 16 and the short circuit parts 18 can be formed by different materials from each other, the performance characteristics required of both front-surface electrode parts 16 and short circuit parts 18 can be imparted.

Further, since the supporting film 11 composed of a metal for supporting the insulating film 13 can be formed by using the laminate material 10A with the insulating film 13 laminated on the surface of the metal film 11A and subjecting the metal film 11A in the laminate material 10A to an etching treatment, positional deviation between the electrode structures and electrodes to be inspected by temperature changes in a burn-in test can be surely prevented even when the object of inspection is a wafer having a large area of 8 inches or greater in diameter or a circuit device, the pitch of electrodes to be inspected of which is extremely small, and thus a sheet-like probe 10 by which a good electrically connected state can be stably retained can be produced.

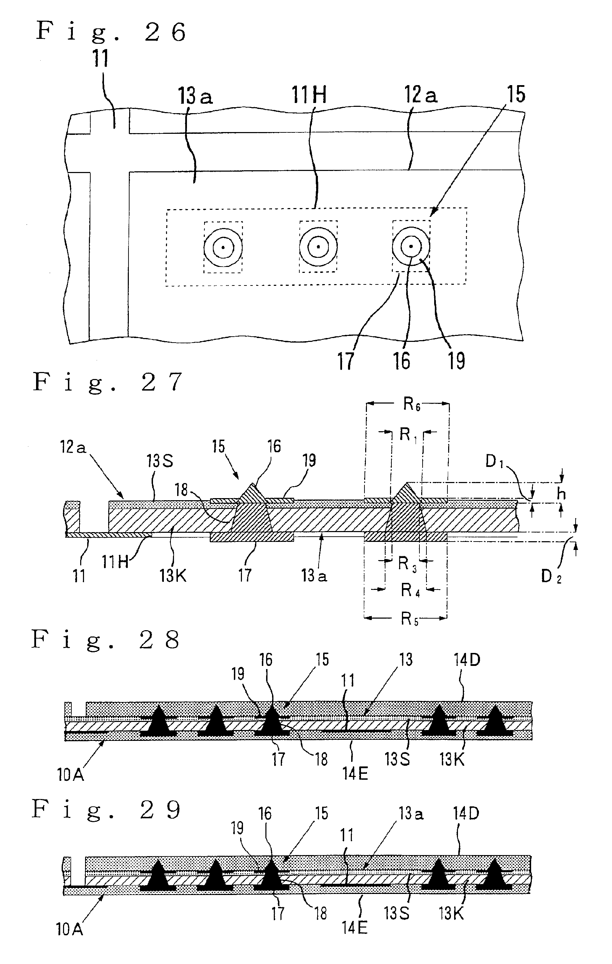

Fig. 25 is a plan view illustrating a sheet-like probe according to a second embodiment of the present invention, Fig. 26 is a plan view illustrating, on an enlarged scale, a principal part of a contact film in the sheet-like probe according to the second embodiment, and Fig. 27 is a cross-sectional view illustrating, on an enlarged scale, the principal part of the sheet-like probe according to the second embodiment.

The sheet-like probe 10 according to the second embodiment is used in conducting electrical inspection of, for example, a wafer, on which a plurality of integrated circuits have been formed, as to each of the integrated circuits in a state of the wafer, and has a supporting film 11 of the same construction as in the sheet-like probe 10 according to the first embodiment.

On a front surface (upper surface in Fig. 27) of this supporting film 11, a plurality of contact films 12a (9 films in the illustrated embodiment) arranged in a state independent of one another so as to align along the front surface are provided integrally with the supporting film 11 and supported thereby.

Each of the contact films 12a has a flexible insulating film 13a. In this insulating film 13a, a plurality of electrode structures 15 each extending in a thickness-wise direction of the insulating film 13a are arranged in relation separated from each other in a plane direction of the insulating film 13a in accordance with a pattern corresponding to a pattern of electrodes to be inspected in a part of integrated circuits formed on a wafer that is an object of inspection. The contact film 12a is arranged in such a manner that the respective electrode structures 15 are located in each of the openings 11H of the supporting film 11.

Each of the electrode structures 15 is composed of a projected front-surface electrode part 16 exposed to a front surface of the insulating film 13a and protruding from the front surface of the insulating film 13a, a rectangular flat plate-like back-surface electrode part 17 exposed to a back surface of the insulating film 13a, a short circuit part 18 extending from the proximal end of the front-surface electrode part 16 through in the thickness-wise direction of the insulating film 13a and linked to the back-surface electrode part 17, and a circular ring plate-like holding part 19 continuously extending from a peripheral surface of a proximal end portion of the front-surface electrode part 16 radially along the surface of the insulating film 13a. A part of the holding part 19 is embedded in the insulating film 13a. In the electrode structures 15 of this embodiment, each front-surface electrode part 16 is formed continuously with the short circuit part 18 in a tapered shape that the diameter becomes gradually small as it goes toward a distal end from a proximal end thereof, i.e., formed in a conical shape as a whole, and the short circuit part 18 continuous with the proximal end of the front-surface electrode part 16 is formed in a tapered shape that the diameter becomes gradually small as it goes toward the front surface from the back surface of the insulating film 13a, i.e., formed in a truncated cone shape as a whole. The short circuit part 18 is formed continuously integrally with the front-surface electrode part 16 by subjecting the proximal end of the front-surface electrode part 16 to a plating treatment.

In the sheet-like probe 10 of the second embodiment, a material and a layer structure of the insulating films 13a, and the construction of the electrode structures 15 are the same as those in the insulating film 13 and electrode structures 15 of the sheet-like probe according to the first embodiment.

The sheet-like probe 10 according to the second embodiment can be produced, for example, in the following manner.

In the same manner as in the production process of the sheet-like probe 10 of the first embodiment, an electrode member-arranging plate 40 of the structure shown in Fig. 4 is first used to form electrode members 16A (see Figs. 10 to 14), and at the same time, a supporting film 11 and electrode structures 15 are formed from a laminate material 10A of the structure shown in Fig. 15 (see Figs. 16 to 24).

After the resist film 14C and the electrode member-arranging plate 40 are removed, a resist film 14D is formed on a front surface of an insulating film 13, front-surface electrode parts 16 and holding parts 19 in accordance with a pattern corresponding to a pattern of contact films 12a to be formed, and a resist film 14E is formed so as to cover a back surface of a supporting film, a back surface of the insulating film 13 and back-surface electrode parts 17 as illustrated in Fig. 28. The insulating film 13 is subjected to an etching treatment to remove exposed portions, whereby the insulating film 13 is divided to form a plurality of insulating films 13a independent of one another as illustrated in Fig. 29, thereby forming a plurality of contact films 12a in each of which a plurality of electrode structures 15 each extending through in a thickness-wise direction of the insulating film 13a are arranged in the insulating film 13a.

The resist film 14D is removed from the front surfaces of the insulating films 13a, the front-surface electrode parts 16 and the holding parts 19, and the resist film 14E is removed from the back surface of the supporting film 11, the back surfaces of the insulating films 13a and the back-surface electrode parts 17, thereby obtaining the sheet-like probe 10 of the second embodiment shown in Figs. 25 to 27.

According to such a sheet-like probe 10 of the second embodiment, the holding part 19 extending in a plane direction of the insulating film 13a is formed at the proximal end portion of the front-surface electrode part 16 in each of the electrode structures 15, so that the electrode structures 16 are prevented from falling off from the insulating film 13 even when the diameter of the front-surface electrode parts 16 is small. In addition, since at least a part of the holding part 19 is embedded in the insulating film 13a, it is prevented from separating from the insulating film 13a, and thus high durability is achieved.

Further, the diameter of the front-surface electrode parts 16 formed can be made small, whereby a clearance between adjoining front-surface electrodes 16 is sufficiently secured, and so flexibility by virtue of the insulating films 13a can be sufficiently exhibited. As a result, a stable electrically connected state can be surely achieved even to a circuit device, on which electrodes have been formed at a small pitch.

Further, since the short circuit parts 18 are formed continuously integrally with the respective front-surface electrode parts 16 by subjecting the proximal ends of the front-surface electrode parts 16 to a plating treatment, whereby the electrode structures having high conductivity can be obtained, and the front-surface electrode parts 16 and the short circuit parts 18 can be formed by different materials from each other, the performance characteristics required of both front-surface electrode parts 16 and short circuit parts 18 can be imparted. For example, the front-surface electrode parts 18 are formed by a metal having high hardness, whereby electrical connection can be surely achieved even to electrodes to be inspected, on which an oxide film has been formed. Alternatively, the front-surface electrode parts 16 are formed by a material hard to be altered by solder, whereby stable conductivity can be retained over a long period of time even when the sheet-like probe is used in inspection of a circuit device having electrodes to be inspected composed of solder. On the other hand, the short circuit parts 18 are formed by a metal having a low electric resistance value, whereby high conductivity is achieved.

Further, since a plurality of openings 11H are formed in the supporting film 11 correspondingly to electrode regions, in which electrodes to be inspected have been formed of a circuit device that is an object of inspection and a plurality of the contact films 12a independent of one another are arranged on the front surface of this supporting film 11 in such a manner that the respective electrode structures 15 are located in the respective openings 11H of the supporting film 11, whereby each of the contact films 12a is supported by the supporting film 11 over the whole surface thereof, the thermal expansion of the insulating films 13a in the plane direction thereof can be surely suppressed by the supporting film 11 even when the contact films 12a each have a large area. Accordingly, positional deviation between the electrode structures 17 and electrodes to be inspected by temperature changes in a burn-in test can be surely prevented even when the object of inspection is a wafer having a large area of, for example, 8 inches or greater in diameter, and the pitch of electrodes to be inspected is extremely small. As a result, a good electrically connected state to the wafer can be stably retained.

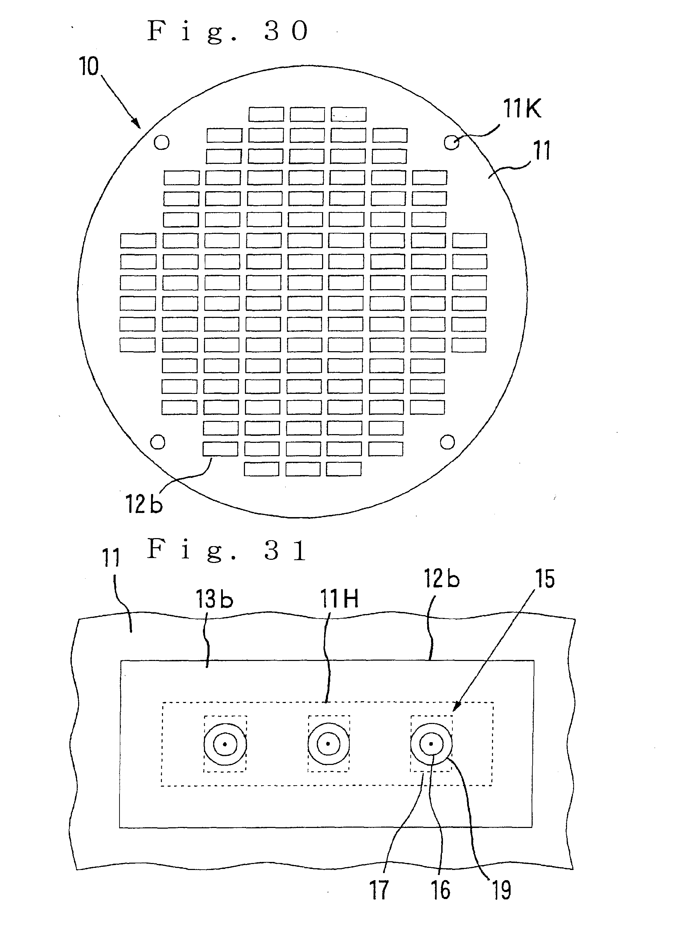

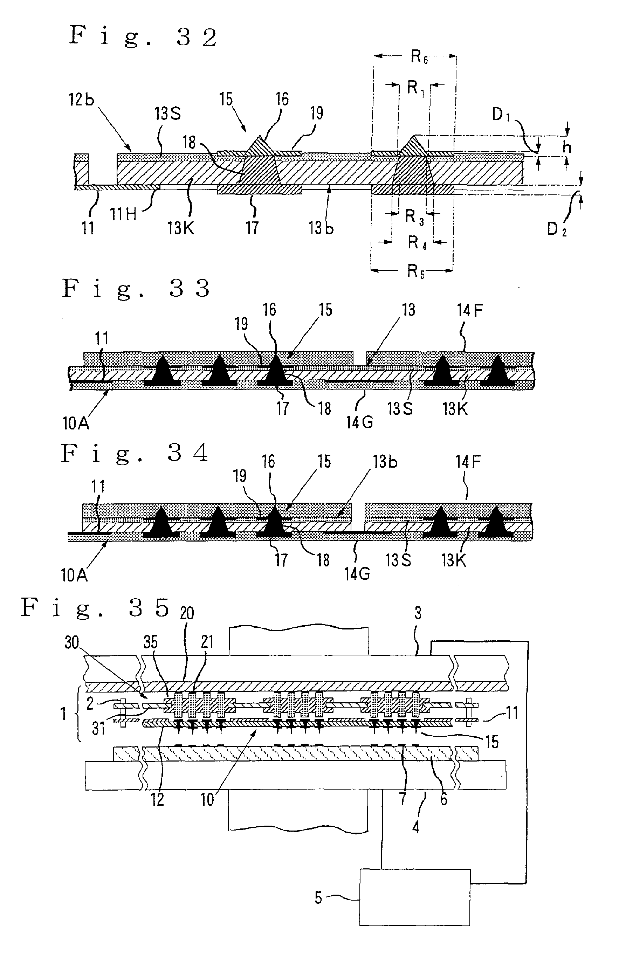

Fig. 30 is a plan view illustrating a sheet-like probe according to a third embodiment of the present invention, Fig. 31 is a plan view illustrating, on an enlarged scale, a principal part of a contact film in the sheet-like probe according to the third embodiment, and Fig. 32 is a cross-sectional view illustrating, on an enlarged scale, the principal part of the sheet-like probe according to the third embodiment.

The sheet-like probe 10 according to the third embodiment is used in conducting electrical inspection of, for example, a wafer, on which a plurality of integrated circuits have been formed, as to each of the integrated circuits in a state of the wafer, and has a supporting film 11 of the same construction as in the sheet-like probe 10 according to the first embodiment.

On a front surface of the supporting film 11, a plurality of contact films 12b are arranged in a state supported by an edge portion about an opening 11H of the supporting film 11 so as to close the opening 11H and in a state independent of adjoining contact films 12b.

Each of the contact films 12b has a flexible insulating film 13b. In this insulating film 13b, a plurality of electrode structures 15 each extending in a thickness-wise direction of the insulating film 13b and composed of a metal are arranged in relation separated from each other in a plane direction of the insulating film 13b in accordance with a pattern corresponding to a pattern of electrodes to be inspected in an electrode region of an integrated circuit formed on a wafer that is an object of inspection. The contact film 12b is arranged in such a manner that the electrode structures 15 are located in each of the openings 11H of the supporting film 11.

Each of the electrode structures 15 is composed of a projected front-surface electrode part 16 exposed to a front surface of the insulating film 13b and protruding from the front surface of the insulating film 13b, a rectangular flat plate-like back-surface electrode part 17 exposed to a back surface of the insulating film 13b, a short circuit part 18 continuously extending from the proximal end of the front-surface electrode part 16 through in the thickness-wise direction of the insulating film 13b and linked to the back-surface electrode part 17, and a circular ring plate-like holding part 19 continuously extending from a peripheral surface of a proximal end portion of the front-surface electrode part 16 outwardly and radially along the front surface of the insulating film 13b. A part of the holding part 19 is embedded in the insulating film 13b. In the electrode structures 15 of this embodiment, each front-surface electrode part 16 is formed continuously with the short circuit part 18 in a tapered shape that the diameter becomes gradually small as it goes toward a distal end from a proximal end thereof, i.e., formed in a conical shape as a whole, and the short circuit part 18 continuous with the proximal end of the front-surface electrode part 16 is formed in a tapered shape that the diameter becomes gradually small as it goes toward the front surface from the back surface of the insulating film 13b, i.e., formed in a truncated cone shape as a whole. The short circuit part 18 is formed continuously integrally with the front-surface electrode part 16 by subjecting the proximal end of the front-surface electrode part 16 to a plating treatment.

In the sheet-like probe 10 of the third embodiment, a material and a layer structure of the insulating films 13b, and the construction of the electrode structures 15 are the same as those in the insulating film 13 and electrode structures 15 of the sheet-like probe according to the first embodiment.

The sheet-like probe 10 according to the third embodiment can be produced, for example, in the following manner.

In the same manner as in the production process of the sheet-like probe 10 of the first embodiment, an electrode member-arranging plate 40 of the structure shown in Fig. 4 is first used to form electrode members 16A (see Figs. 10 to 14), and at the same time, a supporting film 11 and electrode structures 15 are formed from a laminate material 10A of the structure shown in Fig. 15 (see Figs. 16 to 24).

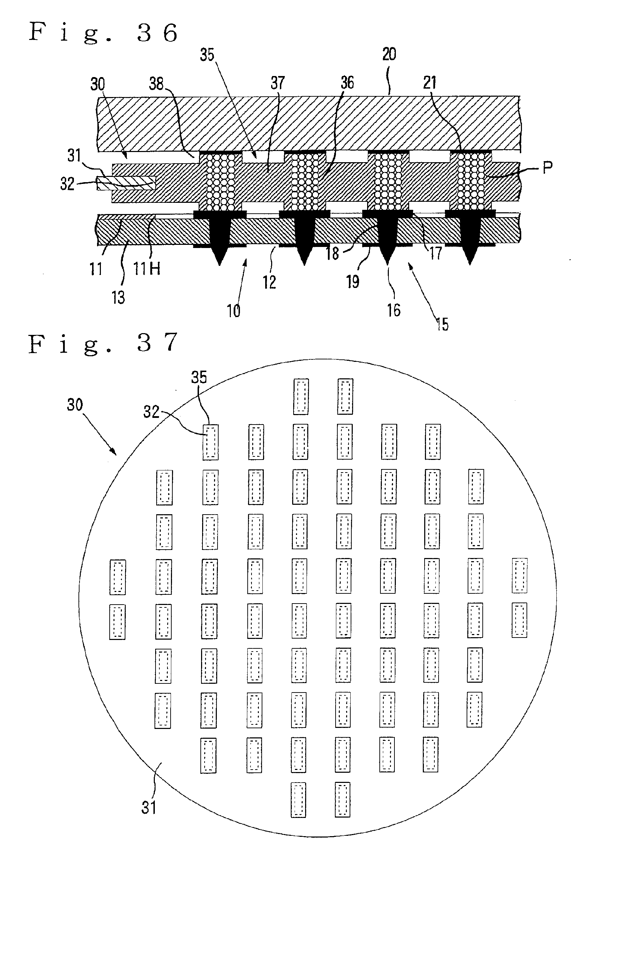

After the resist film 14C and the electrode member-arranging plate 40 are removed, a resist film 14F is formed on a front surface of an insulating film 13, front-surface electrode parts 16 and holding parts 19 in accordance with a pattern corresponding to a pattern of contact films 12b to be formed, and a resist film 14G is formed so as to cover a back surface of a supporting film, a back surface of the insulating film 13 and back-surface electrode parts 17 as illustrated in Fig. 33. The insulating film 13 is subjected to an etching treatment to remove exposed portions, whereby the insulating film 13 is divided to form a plurality of insulating films 13b independent of one another as illustrated in Fig. 34, thereby forming a plurality of contact films 12b in each of which a plurality of electrode structures 15 each extending through in a thickness-wise direction of the insulating film 13b are arranged in the insulating film 13b.

The resist film 14F is removed from the front surfaces of the insulating films 13b, the front-surface electrode parts 16 and the holding parts 19, and the resist film 14G is removed from the back surface of the supporting film 11, the back surfaces of the insulating films 13b and the back-surface electrode parts 17, thereby obtaining the sheet-like probe 10 of the third embodiment shown in Figs. 30 to 32.

According to such a sheet-like probe 10 of the third embodiment, the holding part 19 extending in a plane direction of the insulating film 13b is formed at the proximal end portion of the front-surface electrode part 16 in each of the electrode structures 15, so that the electrode structures 16 are prevented from falling off from the insulating film 13b even when the diameter of the front-surface electrode parts 16 is small. In addition, since at least a part of the holding part 19 is embedded in the insulating film 13b, it is prevented from separating from the insulating film 13b, and thus high durability is achieved.

Further, the diameter of the front-surface electrode parts 16 formed can be made small, whereby a clearance between adjoining front-surface electrodes 16 is sufficiently secured, and so flexibility by virtue of the insulating films 13b can be sufficiently exhibited. As a result, a stable electrically connected state can be surely achieved even to a circuit device, on which electrodes have been formed at a small pitch.

Further, since the short circuit parts 18 are formed continuously integrally with the respective front-surface electrode parts 16 by subjecting the proximal ends of the front-surface electrode parts 16 to a plating treatment, whereby the electrode structures having high conductivity can be obtained, and the front-surface electrode parts 16 and the short circuit parts 18 can be formed by different materials from each other, the performance characteristics required of both front-surface electrode parts 16 and short circuit parts 18 can be imparted. For example, the front-surface electrode parts 18 are formed by a metal having high hardness, whereby electrical connection can be surely achieved even to electrodes to be inspected, on which an oxide film has been formed. Alternatively, the front-surface electrode parts 16 are formed by a material hard to be altered by solder, whereby stable conductivity can be retained over a long period of time even when the sheet-like probe is used in inspection of a circuit device having electrodes to be inspected composed of solder. On the other hand, the short circuit parts 18 are formed by a metal having a low electric resistance value, whereby high conductivity is achieved.

Further, since a plurality of openings 11H are formed in the supporting film 11 correspondingly to electrode regions, in which electrodes to be inspected have been formed in a wafer that is an object of inspection, the contact films 12b arranged in the respective openings 11H may be small in area, and the contact films 12b having a small area is small in the absolute quantity of thermal expansion in the plane direction of the insulating film 13b, the thermal expansion of the insulating films 13b can be surely suppressed by the supporting film 11. Accordingly, positional deviation between the electrode structures 17 and electrodes to be inspected by temperature changes in a burn-in test can be surely prevented even when the object of inspection is a wafer having a large area of, for example, 8 inches or greater in diameter, and the pitch of electrodes to be inspected is extremely small. As a result, a good electrically connected state to the wafer can be stably retained.

### [Probe card and inspection apparatus for circuit devices]

Fig. 35 is a cross-sectional view illustrating the construction of an exemplary inspection apparatus for circuit devices according to the present invention. This inspection apparatus for circuit devices is suitable for respectively conducting electrical inspection of a plurality of integrated circuits formed on a wafer in a state of the wafer.

This inspection apparatus has a probe card 1 for conducting electrical connection between respective electrodes 7 to be inspected of a wafer 6, which is a circuit device to be inspected, and a tester. On a back surface (upper surface in the drawing) of this probe card 1, is provided a pressurizing plate 3 for pressurizing the probe card 1 downward, and a wafer-mounting table 4, on which the wafer 6 is mounted, is provided below the probe card 1. A heater 5 is connected to both pressurizing plate 3 and wafer-mounting table 4.

As also illustrated on an enlarged scale in Fig. 36, this probe card 1 is composed of a circuit board 20 for inspection, on the front surface (lower surface in the drawing) of which a plurality of inspection electrodes 21 have been formed in accordance with a pattern corresponding to a pattern of the electrodes 7 to be inspected in all integrated circuits formed on the wafer 6, an anisotropically conductive connector 30 arranged on the front surface of the circuit board 20 for inspection, and the sheet-like probe 10 of the construction shown in Fig. 1, which is arranged on a front surface (lower surface in the drawing) of this anisotropically conductive connector 30.

The electrode structures 15 in the sheet-like probe 10 are arranged in accordance with the pattern corresponding to the pattern of the electrodes 7 to be inspected in all the integrated circuits formed on the wafer 6.

The anisotropically conductive connector 30 is constructed by a frame plate 31, in which a plurality of openings 32 have been formed corresponding to electrode regions, in which the electrodes 7 to be inspected have been arranged in all the integrated circuits formed on the wafer 6, and a plurality of anisotropically conductive sheets 35 arranged so as to close the respective openings 32 in the frame plate 31 and fixed to and supported by respective opening edges of the frame plate 31 as illustrated in Fig. 37. Each of the anisotropically conductive sheets 35 is formed by an elastic polymeric substance and constructed by a plurality conductive parts 36 formed in accordance with a pattern corresponding to a pattern of electrodes 7 to be inspected in an electrode region, which have been formed on a wafer 6 that is the circuit device to be inspected, and each extending in a thickness-wise direction of the anisotropically conductive sheet, and an insulating part 37 mutually insulating these conductive parts 36. In the embodiment illustrated, projected portions 38 protruding from other surfaces than the portions, at which the conductive parts 36 and peripheral portions thereof are located, are formed at those portions on both sides of the anisotropically conductive sheet 35. In the respective conductive parts 36 in the anisotropically conductive sheet 35, conductive particles P exhibiting magnetism are contained at a high density in a state oriented so as to align in the thickness-wise direction. On the other hand, the insulating part 37 do not contain the conductive particles P at all or scarcely contain them.

The anisotropically conductive connector 30 is arranged on the front surface of the circuit board 20 for inspection in such a manner that the conductive parts 36 are located on the respective inspection electrodes 21, and the sheet-like probe 10 is arranged on the front surface of the anisotropically conductive connector 30 in such a manner that the back-surface electrode parts 17 of the electrode structures 15 are located on the respective conductive part 36. In the embodiment illustrated, guide pins 2 are inserted, respectively, into the positioning holes (not illustrated) formed in the supporting film 11 in the sheet-like probe 10 and the positioning holes (not illustrated) formed in the frame plate 31 in the anisotropically conductive connector 30, and the sheet-like probe 10 and the anisotropically conductive connector 30 are fixed to each other in this state.

As a material for forming the circuit board 20 for inspection, may be used any of conventionally known various materials for boards, and specific examples thereof include composite resin materials such as glass fiber-reinforced epoxy resins, glass fiber-reinforced phenol resins, glass fiber-reinforced polyimide resins and glass fiber-reinforced bismaleimide triazine resins, and ceramic materials such as glass, silicon dioxide and alumina.

When an inspection apparatus for conducting a WLBI (Wafer Lebel Burn-in) test is constructed, that having a coefficient of linear thermal expansion of preferably at most 3 x 10⁻⁵/K, more preferably 1 x 10⁻⁷ to 1 x 10-⁵/K, particularly preferably 1 x 10⁻⁶ to 6 x 10⁻⁶/K is used.

Specific examples of such a board material include Pyrex (Registered trademark) glass, quartz glass, alumina, beryllia, silicon carbide, aluminum nitride and boron nitride.

No particular limitation is imposed on a material for forming the frame plate 31 in the anisotropically conductive connector 30 so far as it has such stiffness as the resulting frame plate 31 is hard to be deformed, and the form thereof is stably retained. For example, various kinds of materials such as metallic materials, ceramic materials and resin materials may be used. When the frame plate 31 is formed by, for example, a metallic material, an insulating film may be formed on the surface of the frame plate 31.

Specific examples of the metallic material for forming the frame plate 31 include metals such as iron, copper, nickel, chromium, cobalt, magnesium, manganese, molybdenum, indium, lead, palladium, titanium, tungsten, aluminum, gold, platinum and silver, and alloys or alloy steels composed of a combination of at least two of these metals.

Specific examples of the resin material forming the frame plate 31 include liquid crystal polymers and polyimide resins.

When the inspection apparatus is that for conducting the WLBI test, the material for forming the frame plate 31 preferably has a coefficient of linear thermal expansion of at most 3 x 10⁻⁵/K, more preferably -1 x 10⁻⁷ to 1 x 10⁻⁵/K, particularly preferably 1 x 10⁻⁶ to 8 x 10⁻⁶/K.

Specific examples of such a material include invar alloys such as invar, Elinvar alloys such as Elinvar, and alloys or alloy steels of magnetic metals, such as superinvar, covar and 42 alloy.

No particular limitation is imposed on the thickness of the frame plate 31 so far as the form thereof is retained, and the anisotropically conductive sheets 35 can be supported. However, the specific thickness thereof is preferably, for example, 25 to 600 µm, more preferably 40 to 400 µm though it varies according to the material thereof.

The overall thickness (thickness of the conductive part 36 in the illustrated embodiment) of the anisotropically conductive sheet 35 in the anisotropically conductive connector 30 is preferably 50 to 2,000 µm, more preferably 70 to 1,000 µm, particularly preferably 80 to 500 µm. When this thickness is 50 µm or greater, sufficient strength is imparted to such an anisotropically conductive sheet 35. When this thickness is 2,000 µm or smaller on the other hand, conductive parts 36 having necessary conductive properties are provided with certainty.

The projected height of the projected portions 38 is preferably at least 10% in total of the thickness of the projected portion 38, more preferably at least 15%. Projected portions 38 having such a projected height are formed, whereby the conductive parts 36 are sufficiently compressed by small pressing force, so that good conductivity is surely achieved.

The projected height of the projected portion 38 is preferably at most 100%, more preferably at most 70% of the shortest width or diameter of the projected portion 38. Projected portions 38 having such a projected height are formed, whereby the projected portions 38 are not buckled when they are pressurized, so that the prescribed conductivity is surely achieved.

The elastic polymeric substance forming the anisotropically conductive sheets 35 is preferably a heat-resistant polymeric substance having a crosslinked structure. As curable polymeric substance-forming materials usable for obtaining such a crosslinked polymeric substance, various materials may be used. However, liquid silicone rubber is preferred.

The liquid silicone rubber may be any of addition type and condensation type. However, addition type liquid silicone rubber is preferred. This addition type liquid silicone rubber is that cured by a reaction of a vinyl group with an Si-H bond and includes a one-pack type (one-component type) composed of polysiloxane having both vinyl group and Si-H bond and a two-pack type (two-component type) composed of polysiloxane having a vinyl group and polysiloxane having an Si-H bond. In the present invention, addition type liquid silicone rubber of the two-pack type is preferably used.

When the anisotropically conductive sheets 35 is formed by a cured product (hereinafter referred to as "cured silicon rubber") of the liquid silicone rubber, the cured silicone rubber preferably has a compression set of at most 10%, more preferably at most 8%, still more preferably at most 6% at 150°C. If the compression set exceeds 10%, the conductive parts 36 tend to cause permanent set when the resulting anisotropically conductive connector is used repeatedly over many times or used repeatedly under high-temperature environment, whereby chains of the conductive particles P in the conductive parts 36 are disordered. As a result, it is difficult to retain the necessary conductivity.

In the present invention, the compression set of the cured silicone rubber can be measured by a method in accordance with JIS K 6249.

The cured silicone rubber preferably has a durometer A hardness of 10 to 60, more preferably 15 to 55, particularly preferably 20 to 50 at 23°C.

If the durometer A hardness is lower than 10, the insulating part 37 mutually insulating the conductive parts 36 are easily over-distorted when pressurized, and it may be difficult in some cases to retain the necessary insulating property between the conductive parts 36. If the durometer A hardness exceeds 60 on the other hand, pressurizing force by a considerably heavy load is required for giving proper distortion to the conductive parts 36, so that a wafer, which is a circuit device to be inspected, tends to cause great deformation or breakage.

Further, if that having a durometer A hardness outside the above range is used as the cured silicone rubber, the conductive parts 36 tend to cause permanent set when the resulting anisotropically conductive connector is used repeatedly over many times, whereby chains of the conductive particles P in the conductive parts 36 are disordered. As a result, it is difficult to retain the necessary conductivity.

When an inspection apparatus for conducting a WLBI test is constructed, the cured silicone rubber for forming the anisotropically conductive sheets 35 preferably has a durometer A hardness of 25 to 40 at 23°C.

If that having a durometer A hardness outside the above range is used as the cured silicone rubber, the conductive parts 36 tend to cause permanent set when the WLBI test is conducted repeatedly, whereby chains of the conductive particles in the conductive parts 36 are disordered. As a result, it is difficult to retain the necessary conductivity.

In the present invention, the durometer A hardness of the cured silicone rubber can be measured by a method in accordance with JIS K 6249.

Further, the cured silicone rubber preferably has tear strength of at least 8 kN/m, more preferably at least 10 kN/m, still more preferably at least 15 kN/m, particularly preferably at least 20 kN/m at 23 °C. If the tear strength is lower than 8 kN/m, the resulting anisotropically conductive sheets 35 tend to deteriorate durability when it is distorted in excess

In the present invention, the tear strength of the cured silicone rubber can be measured by a method in accordance with JIS K 6249.

In the present invention, a proper curing catalyst may be used for curing the addition type liquid silicone rubber. As such a curing catalyst, may be used a platinum-containing catalyst. Specific examples thereof include publicly known catalysts such as platinic chloride and salts thereof, platinum-unsaturated group-containing siloxane complexes, vinylsiloxane-platinum complexes, platinum-1,3-divinyltetramethyldisiloxane complexes, complexes of triorganophosphine or phosphine and platinum, acetyl acetate platinum chelates, and cyclic diene-platinum complexes.

The amount of the curing catalyst used is suitably selected in view of the kind of the curing catalyst and other curing treatment conditions. However, it is generally 3 to 15 parts by weight per 100 parts by weight of the addition type liquid silicone rubber.

In order to, for example, improve the thixotropic property of the addition type liquid silicone rubber, adjust the viscosity, improve the dispersion stability of the conductive particles or provide a base material having high strength, an inorganic filler such as general silica powder, colloidal silica, aerogel silica or alumina may be contained in the addition type liquid silicone rubber as needed.

As the conductive particles P contained in the conductive parts 36, may preferably be used particles obtained by coating the surfaces of core particles (hereinafter also referred to as "magnetic core particles") exhibiting magnetism with high-conductive metal. The term "high-conductive metal" as used herein means a metal having an electric conductivity of at least 5 x 10⁶ Ω⁻¹m⁻¹ at 0°C.

The magnetic core particles for obtaining the conductive particles P preferably have a number average particle diameter of 3 to 40 µm.

In the present invention, the number average particle diameter of the magnetic core particles means a value measured by a laser diffraction scattering method.

When the number average particle diameter is 3 µm or greater, conductive parts 36 easy to deform under pressure, low in resistance value and high in connection reliability can be easily obtained. When the number average particle diameter is 40 µm or smaller on the other hand, minute conductive parts 36 can be easily formed, and the resultant conductive parts 36 tend to have stable conductivity.

Further, the magnetic core particles preferably have a BET specific surface area of 10 to 500 m²/kg, more preferably 20 to 500 m²/kg, particularly preferably 50 to 400 m²/kg.

When the BET specific surface area is 10 m²/kg or wider, such magnetic core particles can be surely plated in a required amount because they have a sufficiently wide platable area. Accordingly, conductive particles P high in conductivity can be obtained, and stable and high conductivity is achieved because a contact area between the conductive particles P is sufficiently wide. When the BET specific surface area is 500 m²/kg or smaller on the other hand, such magnetic core particles do not become brittle, so that they are scarcely broken when physical stress is applied thereto, and stable and high conductivity is retained.

Further, the magnetic core particles preferably have a coefficient of variation of particle diameter of at most 50%, more preferably at most 40%, still more preferably at most 30%, particularly preferably at most 20%.

In the present invention, the coefficient of variation of particle diameter is a value determined in accordance with the expression: (s/Dn) x 100, wherein s is a standard deviation value of the particle diameter, and Dn is a number average particle diameter of the particles.

When the coefficient of variation of particle diameter is 50% or lower, conductive parts 36 narrow in scatter of conductivity can be formed because the evenness of particle diameter is high.

As a material for forming the magnetic core particles, may be used iron, nickel, cobalt, a material obtained by coating such a metal with copper or a resin, or the like. Those having a saturation magnetization of at least 0.1 Wb/m² may be preferably used. The saturation magnetization thereof is more preferably at least 0.3 Wb/m², particularly preferably 0.5 Wb/m². Specific examples of the material include iron, nickel, cobalt and alloys thereof.

As the high-conductive metal coated on the surfaces of the magnetic core particles, may be used gold, silver, rhodium, platinum, chromium or the like. Among these, gold is preferably used in that it is chemically stable and has a high electric conductivity.

In the conductive particles P, a proportion [(mass of high-conductive metal/mass of core particles) x 100] of the high-conductive metal to the core particles is at least 15% by mass, preferably 25 to 35% by mass.

If the proportion of the high-conductive metal is lower than 15% by mass, the conductivity of such conductive particles P is markedly deteriorated when the resulting anisotropically conductive connector is used repeatedly under high-temperature environment. As a result, the necessary conductivity cannot be retained.

The BET specific surface area of the conductive particles P is preferably 10 to 500 m²/kg.

When the BET specific surface area is 10 m²/kg or wider, the surface area of the coating layer becomes sufficiently great, so that the coating layer can be formed as a coating layer great in the total weight of the high-conductive metal. Accordingly, particles high in conductivity can be obtained. In addition, stable and high conductivity can be achieved because a contact area among the conductive particles P is sufficiently wide. When the BET specific surface area is 500 m²/kg or smaller on the other hand, such conductive particles do not become brittle, and thus they are scarcely broken when physical stress is applied thereto, and the stable and high conductivity is retained.

The number average particle diameter of the conductive particles P is preferably 3 to 40 µm, more preferably 6 to 25 µm.

When such conductive particles P are used, the resulting anisotropically conductive sheets 35 become easy to deform under pressure. In addition, sufficient electrical connection is achieved between the conductive particles P in the conductive parts 36.

No particular limitation is imposed on the form of the conductive particles P. However, they are preferably in the form of a sphere or star, or a mass of secondary particles obtained by agglomerating these particles in that these particles can be easily dispersed in the polymeric substance-forming material.

The content of water in the conductive particles P is preferably at most 5% by mass, more preferably at most 3% by mass, further preferably at most 2% by mass, particularly preferably at most 1% by mass. By satisfying such conditions, bubbling can be prevented or inhibited in a curing treatment upon the formation of the anisotropically conductive sheets 35.

The conductive particles P may be those obtained by treating surfaces thereof with a coupling agent such as a silane coupling agent. By treating the surfaces of the conductive particles P with the coupling agent, the adhesion property of the conductive particles P to the elastic polymeric substance is improved. As a result, the resulting anisotropically conductive sheets 35 become high in durability upon repeated use.

The amount of the coupling agent used is suitably selected within limits not affecting the conductivity of the conductive particles P. However, it is preferably such an amount that a coating rate (proportion of an area coated with the coupling agent to the surface area of the conductive particles) of the coupling agent on the surfaces of the conductive particles P amounts to at least 5%, more preferably 7 to 100%, further preferably 10 to 100%, particularly preferably 20 to 100%.

Such conductive particles P may be obtained in accordance with, for example, the following process.

Particles are first formed from a ferromagnetic material, or commercially available particles of a ferromagnetic substance are provided. The particles are subjected to a classifying treatment to prepare magnetic core particles having a required particle diameter.

In the present invention, the classification treatment of the particles can be conducted by means of, for example, a classifier such as an air classifier or sonic classifier.

Specific conditions for the classification treatment are suitably preset according to the intended number average particle diameter of the magnetic core particles, the kind of the classifier, and the like.

Surfaces of the magnetic core particles are then treated with an acid and further washed with, for example, purified water, thereby removing impurities such as dirt, foreign matter and oxide films present on the surfaces of the magnetic core particles. Thereafter, the surfaces of the magnetic core particles are coated with a high-conductive metal, thereby obtaining conductive particles.

As examples of the acid used for treating the surfaces of the magnetic core particles, may be mentioned hydrochloric acid.

As a method for coating the surfaces of the magnetic core particles with the high-conductive metal, may be used electroless plating, displacement plating or the like. However, the method is not limited to these methods.

A process for producing the conductive particles by the electroless plating or displacement plating will be described. The magnetic core particles subjected to the acid treatment and washing treatment are first added to a plating solution to prepare a slurry, and electroless plating or displacement plating is conducted on the magnetic core particles while stirring the slurry. The particles in the slurry are then separated from the plating solution. Thereafter, the particles separated are subjected to a washing treatment with, for example, purified water, thereby obtaining conductive particles with the surfaces of the magnetic core particles coated with the high-conductive metal.

Alternatively, primer plating may be conducted on the surfaces of the magnetic core particles to form a primer plating layer, and a plating layer composed of the high-conductive metal may be then formed on the surface of the primer plating layer. No particular limitation is imposed on the process for forming the primer plating layer and the plating layer formed thereon. However, it is preferable to form the primer plating layer on the surfaces of the magnetic core particles by the electroless plating and then form the plating layer composed of the high-conductive metal on the surface of the primer plating layer by the displacement plating.

No particular limitation is imposed on the plating solution used in the electroless plating or displacement plating, and various kinds of commercially available plating solutions may be used.

Since conductive particles having a great particle diameter may be produced due to aggregation of the magnetic core particles upon the coating of the surfaces of the particles with the high-conductive metal, the resultant conductive particles are preferably classified as needed. By conducting the classification treatment, the conductive particles having the expected particle diameter can be surely obtained.

As examples of a classifier used for conducting the classification treatment of the conductive particles, may be mentioned those exemplified as the classifier used in the classification treatment of the magnetic core particles.

The proportion of the conductive particles P contained in the conductive parts 36 is preferably 10 to 60%, more preferably 15 to 50% in terms of volume fraction. If this proportion is lower than 10%, conductive parts 36 sufficiently low in electric resistance value may not be obtained in some cases. If the proportion exceeds 60% on the other hand, the resulting conductive parts 36 are liable to be brittle, so that elasticity required of the conductive parts 36 may not be achieved in some cases.

Such an anisotropically conductive connector as described above can be produced in accordance with, for example, the process described in Japanese Patent Application Laid-Open No. 2002-324600.

In the above-described inspection apparatus, a wafer 6, which is an object of inspection, is mounted on the wafer-mounting table 4, and the probe card 1 is then pressurized downward by the pressurizing plate 3, whereby the respective front-surface electrode parts 16 in the electrode structures 15 of the sheet-like probe 10 thereof are brought into contact with their corresponding electrodes 7 to be inspected of the wafer 6, and moreover the respective electrodes 7 to be inspected of the wafer 6 are pressurized by the front-surface electrodes parts 16. In this state, the conductive parts 36 in each anisotropically conductive sheet 35 of the anisotropically conductive connector 30 are respectively held and pressurized by the inspection electrodes 21 of the circuit board 20 for inspection and the back-surface electrode parts 17 in the electrode structures 15 of the sheet-like probe 10 and compressed in the thickness-wise direction of the anisotropically conductive sheet 35, whereby conductive paths are formed in the respective conductive parts 36 in the thickness-wise direction thereof. As a result, electrical connection between the electrodes 7 to be inspected of the wafer 6 and the inspection electrodes 21 of the circuit board 20 for inspection is achieved. Thereafter, the wafer 6 is heated to a prescribed temperature by the heater 5 through the wafer-mounting table 4 and the pressurizing plate 3. In this state, necessary electrical inspection is curried out on each of a plurality of integrated circuits on the wafer 6.

According to the above-described probe card 1, the following effects are brought about.
(1) Since the sheet-like connector 10 shown in Fig. 1 is provided, a stable electrically connected state can be surely achieved even to a wafer 6, on which electrodes 7 to be inspected have been formed at a small pitch. In addition, since the electrode structures 15 in the sheet-like probe 10 are prevented from falling off, high durability is achieved.
(2) Since the whole of the contact film 12 in the sheet-like probe 10 is supported by the supporting film 11, positional deviation between the electrode structures 15 and the electrodes 7 to be inspected by temperature changes can be surely prevented.

In addition, since the respective openings 32 of the frame plate 31 in the anisotropically conductive connector 30 are formed corresponding to electrode regions, in which electrodes 7 to be inspected have been formed of all the integrated circuits in the wafer 6 that is the object of inspection, the anisotropically conductive sheets 35 arranged in the respective openings 32 may be small in area, and the anisotropically conductive sheets 35 having the area is small in the absolute quantity of thermal expansion in the plane direction thereof, the thermal expansion of the anisotropically conductive sheets 35 in the plane direction can be surely suppressed by the frame plate 31. As a result, positional deviation between the conductive parts 36 and the electrode structures 15 by temperature changes can be surely prevented.

Accordingly, even when the wafer 6 that is the object of inspection has a large area of, for example, 8 inches or greater in diameter, and the pitch of the electrodes to be inspected is extremely small, a good electrically connected state to the wafer can be stably retained in a burn-in test.

According to the inspection apparatus having such a probe card 1, a stable electrically connected state can be surely achieved even to a wafer 6, on which electrodes 7 to be inspected have been formed at a small pitch. In addition, since the probe card 1 has high durability, inspection can be performed with high reliability over a long period of time even when the inspection is conducted as to a great number of wafers. Further, even when the wafer 6 has a large area of, for example, 8 inches or greater in diameter, and the pitch of the electrodes 7 to be inspected is extremely small, a good electrically connected state to the wafer can be stably retained in a burn-in test, and necessary electrical inspection can be surely performed as to a plurality of integrated circuits in the wafer 6.

The inspection apparatus for circuit devices according to the present invention is not limited to the above-described wafer inspection apparatus, and various changes or modifications may be added thereto as described below.
(1) The probe card 1 shown in Figs. 35 and 36 is intended to achieve electrical connection collectively as to electrodes 7 to be inspected of all the integrated circuits formed on the wafer 6. However, it may be electrically connected to electrodes 7 to be inspected of a plurality of integrated circuits selected from among all the integrated circuits formed on the wafer 6. The number of integrated circuits selected is suitably selected in view of the size of the wafer 6, the number of integrated circuits formed on the wafer 6, the number of electrodes to be inspected in each integrated circuit, and the like. For example, the number is 16, 32, 64 or 128.
   In the inspection apparatus having such a probe card 1, the probe card 1 is electrically connected to electrodes 7 to be inspected of a plurality of integrated circuits selected from among all the integrated circuits formed on the wafer 6 to conduct inspection. Thereafter, the probe card 1 is electrically connected to electrodes 7 to be inspected of a plurality of integrated circuits selected from among other integrated circuits to conduct inspection. This process is repeated, whereby electrical inspection of all the integrated circuits formed on the wafer 6 can be conducted.
   According to such an inspection apparatus, the numbers of inspection electrodes and wires in a circuit board for inspection used can be reduced compared with a method of collectively conducting inspection as to all integrated circuits in the case where electrical inspection is conducted as to integrated circuits formed in a high degree of integration on a wafer having a diameter of 8 or 12 inches, whereby production cost of the inspection apparatus can be reduced.
(2) In the sheet-like probe 10, a ring-like holding member 60 may be provided at a peripheral edge portion of the supporting film 11 as illustrated in Fig. 38.
   As a material for forming such a holding member 60, may be used an invar alloy such as invar or superinvar, an Elinvar alloy such as Elinvar, a low-thermal expansion metallic material such as covar or 42 alloy, or a ceramic material such as alumina, silicon carbide or silicon nitride.
(3) The form of the front-surface electrode parts 16 is not limited to the conical form, and it may be in the form of, for example, a truncated cone, pyramid, truncated pyramid or the like. However, it is preferably in a conical or pyramidal form such as a cone or pyramid in that stable electrical connection to electrodes to be inspected of a wafer can be achieved by small pressurizing force. The form of the front-surface electrode parts 16 can be changed by changing the form of the recesses 41 of the electrode member-arranging plate 40.
   In order to form, for example, pyramidal recesses 41 in the electrode member-arranging plate 40, it is only necessary to make the form of the patterned holes 45K in the resist film 45 formed on the surface of the arranging plate-forming material 40A polygonal.
   Also, in order to form truncated cone recesses 41 in the electrode member-arranging plate 40, it is only necessary to form conical recesses in the arranging plate-forming material 40A once and then fill a proper amount of a liquid resist or the like into these recesses to cure it.
(4) In addition to the conductive parts 36 formed in accordance with the pattern corresponding to the pattern of the electrodes 7 to be inspected, conductive parts for non-connection that are not electrically connected to any electrode 7 to be inspected may be formed in the anisotropically conductive sheets 35 in the anisotropically conductive connector 30.
(5) The inspection apparatus according to the present invention is not limited to the wafer inspection apparatus, and it may be constructed as an inspection apparatus for circuits formed in a semiconductor chip, a packaged LSI such as BGA and CSP, a semiconductor integrated circuit device such as MCM, or the like.
(6) In the production process for the sheet-like probe, after the electrode members are formed in the electrode member-arranging plate, the electrode members are press-bonded to the insulating film without removing the metal layer formed on the front surface of the electrode member-arranging plate, whereby the metal layer can be used as a common electrode to form the short circuit parts by electroplating. In such a process, the metal layer bonded to the insulating film by the press-bonding treatment can be removed by an etching treatment.
(7) The electrode members 16A, the short circuit parts 18 and the back-surface electrode parts 17 may be formed by the same plating method or different plating methods from one another. For example, the electrode members 16A are formed by electroplating with nickel, whereby front-surface electrode parts 16 by hard nickel plating are obtained, while the short circuit parts 18 and the back-surface electrode parts 17 are formed by chemical nickel plating, whereby short circuit parts 18 and back-surface electrode parts 17 relatively low in hardness are obtained, thus permitting forming front-surface electrode parts 16, and short circuit parts 18 and back-surface electrode parts 17 which are different in physical property from each other.
(8) The electrode members 16A, the short circuit parts 18 and the back-surface electrode parts 17 may be formed by respective alloys comprising, as a principal component, the same metal and containing trace metal components different from one another. For example, the electrode members 16A are formed by an alloy obtained by adding cobalt or the like to nickel, whereby hard front-surface electrode parts 16 are obtained, while the short circuit parts 18 and the back-surface electrode parts 17 are formed by nickel, whereby short circuit parts 18 and back-surface electrode parts 17 relatively low in hardness are obtained, thus permitting forming front-surface electrode parts 16, and short circuit parts 18 and back-surface electrode parts 17 which are different in physical property from each other.

### EXAMPLES

The present invention will hereinafter be described specifically by the following examples. However, the present invention is not limited to these examples.

### [Production of wafer for test]

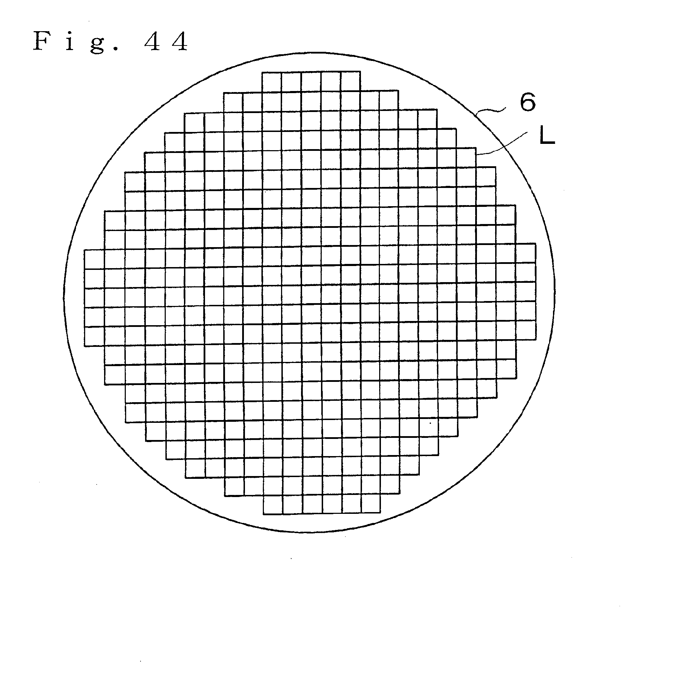

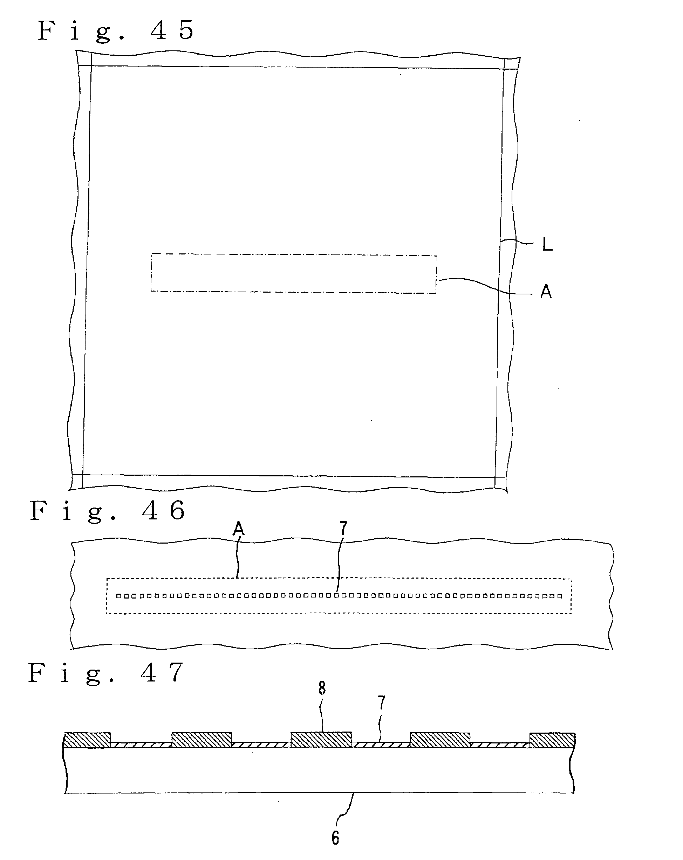

As illustrated in Fig. 44, 393 square integrated circuits L in total, which each had dimensions of 6.5 mm x 6.5 mm, were formed on a wafer 6 made of silicon (coefficient of linear thermal expansion: 3.3 x 10⁻⁶/K) and having a diameter of 8 inches. Each of the integrated circuits L formed on the wafer 6 has a region A of electrodes to be inspected at its center as illustrated in Fig. 45. In the region A of the electrodes to be inspected, as illustrated in Fig. 46, 50 rectangular electrodes 7 to be inspected each made of aluminum and having dimensions of 50 µm x 50 µm are arranged at a pitch of 120 µm in a line in a lateral direction.

As illustrated in Fig. 47, an insulating film 8 having a thickness of about 10 µm and composed of polyimide is formed on other regions than portions where the electrodes 7 to be inspected have been arranged in the integrated circuit.

The total number of the electrodes 7 to be inspected in the whole wafer 6 is 19,650. Every two electrodes among the 50 electrodes 7 to be inspected in the integrated circuit L are electrically connected to each other every second electrode counting from an endmost electrode 7 to be inspected.

This wafer will hereinafter be referred to as "Wafer W for test".

### <Example 1>

(1) Production of electrode member-arranging plate:
   An arranging plate-forming material (40A) composed of a silicon wafer, which was formed of monocrystal silicon having a crystal face (1,0,0) as a surface and had a diameter of 200 mm, on both surfaces of which protecting films (42, 43) each having a thickness of 750 Å and formed of silicon dioxide (SiO₂) had been formed, was provided (see Fig. 5).
   A negative thick-film photoresist "THB-124N" (product of JSR Corporation) was applied on to the respective surfaces of the protecting films (42, 43) formed on the arranging plate-forming material (40A). The coating films were prebaked under conditions of 100°C for 15 minutes in an oven, thereby forming resist films (45, 46) each having a thickness of 15 µm (see Fig. 6).
   After the resist film (45) was then subjected to an exposure treatment by irradiation of ultraviolet light of 1,500 mJ/cm² (365 nm) through a photomask by means of a high-pressure mercury lamp, a development treatment was conducted by repeating a process of immersing the arranging plate-forming material for 90 seconds in a 0.5% by volume aqueous solution of TMAH (tetramethylammonium hydroxide) twice. After the thus-developed resist film was postbaked under conditions of 130°C for 20 minutes, post-exposure was conducted with 2,000 mJ/cm² (365 nm), whereby patterned rectangular holes 45K having dimensions of 50 µm in a vertical direction and 50 µm in a lateral direction were formed in accordance with a pattern corresponding to a pattern of the electrodes to be inspected formed on Wafer W for test (see Fig. 7). On the other hand, the whole surface of the resist film (46) was subjected to the same exposure treatment as described above and then postbaked under conditions of 130°C for 20 minutes.
   The arranging plate-forming material (40A), on which the resist films (45, 46) had been formed, was immersed for 10 minutes at room temperature in a 4.6% by volume aqueous solution of hydrofluoric acid to subject the protecting film (42) formed on one surface of the arranging plate-forming material (40A) to an etching treatment through the patterned holes (45K) of the resist film (45), whereby patterned holes (42K) linked to the respective patterned holes (45K) of the resist film (45) were formed in the protecting film (42) (see Fig. 8). Thereafter, the arranging plate-forming material was immersed for 2 minutes at 40°C in a DMSO (dimethyl sulfoxide) solution containing 2% by volume of TMAH (tetramethylammonium hydroxide) to dissolve off and remove the resist films (45, 46) formed on the surfaces of the protecting films (42, 43).
   The arranging plate-forming material (40A) was then subjected to an anisotropic etching treatment through the patterned holes (42K) of the protecting film (42) using the protecting films (42, 43) as resists, thereby forming, in the arranging plate-forming material (40A), pyramidal recesses (41) each having dimensions of 50 µm in a vertical direction of an opening in the front surface thereof, 50 µm in a lateral direction thereof, 35 µm in depth and an angle of a tapered surface to the front surface of 47° (see Fig. 4).
   In the above-described process, the anisotropic etching treatment was conducted by shaking and immersion for 40 minutes in a 40% by weight aqueous solution of potassium hydroxide heated to 80°C.
   An electrode member-arranging plate (40), in which the recesses (41) had been formed in accordance with a pattern corresponding to a pattern of front-surface electrode parts in a sheet-like probe to be produced, was obtained in such a manner.
(2) Production of intermediate composite material:
   A negative thick-film photoresist "THB-124N" (product of JSR Corporation) was applied on to the surface of electrode member-arranging plate (40), in which the recesses (41) had been formed, so as to give a coating thickness of 25 µm. The resultant coating film was prebaked under conditions of 100°C for 20 minutes in an oven, and the dry film thus obtained was subjected to an exposure treatment by irradiation of ultraviolet light of 1,700 mJ/cm² (365 nm) through a photomask by means of a high-pressure mercury lamp. Thereafter, a development treatment for the coating film was conducted by repeating a process of immersing the electrode member-arranging plate (40), on which the coating film had been formed, for 120 seconds in a 0.5% by volume aqueous solution of TMAH (tetramethylammonium hydroxide) twice. The thus-developed coating film was then postbaked under conditions of 130°C for 20 minutes, and further post-exposure treatment was conducted by irradiation of ultraviolet light of 2,500 mJ/cm² (365 nm), thereby forming a resist film (47) of 10 µm thick, which had rectangular patterned holes (47K) each linked to the recess (41) of the electrode member-arranging plate (40) and having dimensions of 70 µm in a lateral direction and 220 µm in a vertical direction (see Fig. 10).
   The surface of the resist film (47) and regions exposed through the patterned holes (47K) of the resist film (47) in the surface of the electrode member-arranging plate (40) were then subjected to a sputtering treatment under conditions of 0.25 kW for 15 minutes by means of a sputtering apparatus (manufactured by ANELVA Corporation), thereby forming a metal layer (50) composed of copper (see Fig. 11). A negative thick-film photoresist "THB-124N" (product of JSR Corporation) was applied on to the surface of the metal layer (50) so as to give a coating thickness of 25 µm. The resultant coating film was prebaked under conditions of 100°C for 20 minutes in an oven, and the dry film thus obtained was subjected to an exposure treatment by irradiation of ultraviolet light of 1,700 mJ/cm² (365 nm) through a photomask by means of a high-pressure mercury lamp. Thereafter, a development treatment for the coating film was conducted by repeating a process of immersing the electrode member-arranging plate (40), on which the coating film had been formed, for 120 seconds in a 0.5% by volume aqueous solution of TMAH (tetramethylammonium hydroxide) twice. The thus-developed coating film was then postbaked under conditions of 130°C for 20 minutes, and further post-exposure was conducted by irradiation of ultraviolet light of 2,500 mJ/cm² (365 nm), thereby forming a resist film (48) having patterned holes (48K) each linked to the patterned hole (47K) of the resist film (47) at portions located on the resist film (47) in the metal layer (50) (see Fig. 12).
   The electrode member-arranging plate (40), on which the resist film (48) had been formed, was then immersed in a plating solution "NIPHOLLOY PROCESS" (product of Kizai Corporation) for forming hard nickel (nickel-phosphorus alloy) coating to conduct an electroplating treatment under conditions of 55°C, 2 A/dm² and 35 minutes using the metal layer (50) formed on the front surface of the electrode member-arranging plate (40) as a common electrode, thereby forming electrode members (16A) made of a nickel-phosphorus alloy and each constructed by a front-surface electrode part (16) and a holding part (19) continuously extending from a proximal end portion of the front-surface electrode part in a plane direction of the electrode member-arranging plate (40) and having a thickness of 10 µm.
   The electrode member-arranging plate (40) was then immersed for 5 minutes at 40°C in a DMSO (dimethyl sulfoxide) solution containing 2% by volume of TMAH (tetramethylammonium hydroxide), whereby the resist film (48), the metal layer (50) and resist film (47) were removed from the surface of the electrode member-arranging plate (40), thereby producing an intermediate composite material (40B), in which a plurality of electrode members (16A) were arranged in accordance with the pattern corresponding to the pattern of the electrode structures to be formed (see Fig. 14).
(3) Production of laminate material:
   A laminated polyimide sheet with a circular metal film (11A) having a thickness of 10 µm and a diameter of 22 cm and composed of 42 alloy integrally laminated with a circular polyimide sheet having a diameter of 20 cm and a thickness of 25 µm was provided, and a protecting tape having an inner diameter of 20.4 cm and an outer diameter of 22 cm and composed of polyethylene terephthalate was disposed at a peripheral edge portion of the surface of the metal film (11A) of the laminated polyimide sheet, on which the polyimide sheet had been laminated. A process of coating the surface of the polyimide sheet with polyimide varnish (product of Ube Industries, Ltd., trade name "U-Varnish") and drying it was conducted repeatedly, thereby producing a laminate material (10A) having a metal film (11A) and an insulating film (13) integrally laminated on the surface of the metal film (11A), said insulating film being obtained by integrally laminating a surface layer (13S) having a thickness of 15 µm and composed of an adhesive polyimide resin on a base layer (13K) composed of a polyimide resin (see Fig. 15).
   The intermediate composite material (40B) was arranged on the surface layer (13S) of the insulating film (13) in this laminate material (10A) so as to bring the electrode members (16A) into contact with the surface layer. In this state, a heating and press-bonding treatment is conducted, thereby bonding the electrode members (16A) to the insulating film (13) (see Fig. 16). The thickness of the insulating film (13) after the heating and press-bonding treatment was 37 µm.
(4) Production of sheet-like probe:
   On the back surface of the metal film (11A) in the laminate material (10A), a resist film (14A), in which 19,650 circular patterned holes (K1) each having a diameter of 80 µm were formed in accordance with a pattern corresponding to the pattern of the electrodes to be inspected formed on Wafer W for test, was formed by a dry film resist "H-K350" (product of Hitachi Chemical Co., Ltd.) having a thickness of 25 µm (see Fig. 17). In the formation of the resist film (14A), an exposure treatment was conducted by irradiation of ultraviolet light of 80 mJ by means of a high pressure mercury lamp, and a development treatment was conducted by repeating a process of immersing the laminate material for 40 seconds in a developer composed of a 1% aqueous solution of sodium hydroxide twice.
   Portions exposed through the patterned holes (K1) of resist film (14A) in the metal layer (11A) were then subjected to an etching treatment with a ferric chloride etchant under conditions of 50°C for 30 seconds to remove those portions, thereby forming, in the metal layer (11A), 19,650 patterned holes (17H) linked to the respective patterned holes (K1) of the resist film (14A) (see Fig. 18). Thereafter, the insulating film (13) was subjected to an etching treatment with an amine type polyimide etchant "TPE-3000" (product of Toray Engineering Co., Ltd.,) under conditions of 80°C for 15 minutes, thereby forming, in the insulating film (13), 19,650 through-holes (13H) linked to the respective patterned holes (17H) of the metal film (11A) (see Fig. 19). Each of the through-holes (13H) was in a tapered form that the diameter becomes gradually small from the back surface of the insulating film (13) toward the front surface thereof, and had an opening diameter of 80 µm on the back surface side and an opening diameter of 35 µm on the front surface side.

The laminate material (10A), in which the through-holes (13H) had been formed, was then immersing for 2 minutes in a sodium hydroxide solution at 45°C, thereby removing the resist film (14A) from the laminate material (10A). Thereafter, the laminate material (10A) was subjected to a sputtering treatment under conditions of 0.25 kW for 15 minutes by means of a sputtering apparatus (manufactured by ANELVA Corporation), whereby a thin metal layer (13M) composed of copper was formed on an inner wall surface of each of the through-holes (13H) in the laminate material (10A). A dry film resist "H-K350" (product of Hitachi Chemical Co., Ltd.) having a thickness of 25 µm was arranged so as to cover the whole back surface of the metal film (11A) of the laminate material (10A) to conduct an exposure treatment and a development treatment, thereby forming, on the back surface of the metal film (11A), a resist film (14B) which had 19,650 patterned rectangular holes (K2) linked to the respective through-holes (13H) of the insulating film (13) and each having dimensions of 200 µm x 80 µm (see Fig. 20). In the formation of the resist film (14B), an exposure treatment was conducted by irradiation of ultraviolet light of 80 mJ by means of a high-pressure mercury lamp, and a development treatment was conducted by repeating a process of immersing the laminate material for 40 seconds in a developer composed of a 1% aqueous solution of sodium hydroxide twice.

The laminate material (10A) was then immersed in a plating bath containing nickel sulfamate to subject the laminate material (10A) to an electroplating treatment by using the metal film (11A) as an electrode to fill a metal into the through-holes (13H) of the insulating film (13), the patterned holes (17H) of the metal layer (11A) and the patterned holes (K2) of the resist film (14B), thereby forming short circuit parts (18) each extending in a thickness-wise direction of the insulating film (13) continuously with the proximal end of the front-surface electrode part (16), and back-surface electrode parts (17) linked to the respective short circuit parts (18), thus forming the electrode structures (15) (see Fig. 21).

The laminate material (10A), in which the electrode structures (15) had been formed, was then immersed for 2 minutes in a sodium hydroxide solution at 45°C, thereby removing the resist film (14B) from the laminate material (10A) (see Fig. 22). A dry film resist "H-K350" (product of Hitachi Chemical Co., Ltd.) having a thickness of 25 µm was then arranged so as to cover the whole back surface of the metal film (11A) including the back-surface electrode parts (17) to conduct an exposure treatment and a development treatment, thereby forming a patterned resist film (14C) so as to cover a portion to become a supporting film in the metal film (11A) and the back-surface electrode parts (17) (see Fig. 23). In the formation of the patterned resist film (14C), an exposure treatment was conducted by irradiation of ultraviolet light of 80 mJ by means of a high-pressure mercury lamp, and a development treatment was conducted by repeating a process of immersing the laminate material for 40 seconds in a developer composed of a 1% aqueous solution of sodium hydroxide twice.

The exposed portions of the metal film (11A) were then subjected to an etching treatment with an ammonia etchant under conditions of 50°C for 30 seconds to remove those portions, thereby separating the back-surface electrode parts (17) from one another and moreover forming a supporting film (11) having 393 openings (11H) formed in accordance with a pattern corresponding to the pattern of the electrode regions in the integrated circuits formed on Wafer W for test (see Fig. 24). The openings (11H) in the supporting film (11) each had dimensions of 3,600 µm in a lateral direction and 1,000 µm in a vertical direction.

The laminate material (10A), on which the supporting film (11) had been formed, was then immersed for 2 minutes in an aqueous solution of sodium hydroxide at 45°C, thereby removing the resist film (14C) from the back surface of the supporting film (11) and the back-surface electrode parts (17). Thereafter, the electrode member-arranging plate (40) was removed. A resist film (14G) was then formed with a dry film resist "H-K350" (product of Hitachi Chemical Co., Ltd.) having a thickness of 25 µm, so as to cover the back surface of the supporting film (11), the back surface of the insulating film (13) and the back-surface electrode parts (17). On the other hand, a dry film resist "H-K350" (product of Hitachi Chemical Co., Ltd.) having a thickness of 25 µm was arranged so as to cover the front surface of the insulating film (13), the front-surface electrode parts (16) and the holding parts (19) to conduct an exposure treatment and a development treatment, thereby forming a resist film (14F) patterned in accordance with a pattern corresponding to a pattern of contact films (12b) to be formed (see Fig. 33).

The insulating film (13) was then subjected to an etching treatment with an amine type polyimide etchant ("TPE-3000", product of Toray Engineering Co., Ltd.,) under conditions of 80°C for 10 minutes, thereby dividing the insulating film (13) to form 393 insulating films (13b), thus forming 393 contact films (12b) (see Fig. 34). Thereafter, the laminate material was immersed for 2 minutes in an aqueous solution of sodium hydroxide at 45°C, thereby removing the resist film (14F) and the resist film (14G).

The protecting tape was then removed from the peripheral edge portion in the supporting film (11), the surface of the peripheral edge portion in the supporting film (11) was coated with a 2-pack type acrylic adhesive "Y-620" (product of Cemedine Co., Ltd.), a ring-like holding member composed of silicon nitride and having an outer diameter of 22 cm, an inner diameter of 20.5 cm and a thickness of 2 mm was arranged, and the holding member and the supporting film (11) were pressurized under a load of 50 kg and held for 8 hours at 25°C, thereby fixing the holding member to the supporting film (11), thus producing a sheet-like probe (10) according to the present invention (see Figs. 30 to 32).

The shapes and dimensions of the respective parts of the sheet-like probe (10) thus obtained were as follows.

The insulating film (13b) had dimensions of 4,800 µm in a lateral direction, 2,000 µm in a vertical direction and about 37 µm in overall thickness, in which the thickness of the base layer (13K) was 25 µm, and the thickness of the surface layer (13S) was about 12 µm.

The shape of the front-surface electrode part (16) in the electrode structure (15) was of a truncated pyramid, the dimensions (R1) of the proximal end thereof were 50 µm x 50 µm, and the projected height (h) was 35 µm. The shape of the short circuit part (18) was of a truncated cone, the diameter (R₃) of one end on the front surface side thereof was 35 µm, and the diameter (R₄) of the other end on the back surface side thereof was 80 µm. The shape of the back-surface electrode part (17) was of a rectangular flat plate, the width (R₅) thereof was 80 µm, the length thereof was 200 µm, and the thickness (D₂) was 35 µm. The shape of the holding part (19) was of a rectangular flat plate, the width (R₆) thereof was 80 µm, the length thereof was 220 µm, and the thickness (D₁) was 10 µm. A part of the holding part (19) was embedded in the surface layer (13S) of the insulating film (13).

The composition of the material forming the front-surface electrode parts (16) was analyzed by means of an Auger electron spectrometer. As a result, it was found to contain 85% by weight of nickel and 15% by weight of phosphorus.

A thin metal film having a thickness of 5 µm was formed on a silicon wafer by an electroplating treatment under the same conditions as in the formation of the front-surface electrode parts (16) to measure a Vickers hardness of this thin metal film by means of a "Dynamic Micro Hardness Tester" (manufactured by Shimadzu Corporation). As a result, the hardness was 800.

### <Example 2>

A sheet-like probe (10) according to the present invention was produced in the same manner as in Example 1 except that in the formation of the electrode members (16) in Example 1, a nickel-phosphorus plating solution "Nikkerin B" (product of Okuno Chemical Industries Co., Ltd.) was used as the plating solution in place of "NIPHOLLOY PROCESS" (product of Kizai Corporation), and the treating temperature of the electroplating treatment was changed from 55°C to 65°C.

The shapes and dimensions of the respective parts of the sheet-like probe (10) thus obtained were the same as in the sheet-like probe (10) according to Example 1.

The composition of the material forming the front-surface electrode parts (16) was analyzed by means of an Auger electron spectrometer. As a result, it was found to contain 90% by weight of nickel and 10% by weight of phosphorus.

A thin metal film having a thickness of 5 µm was formed on a silicon wafer by an electroplating treatment under the same conditions as in the formation of the front-surface electrode parts (16) to measure a Vickers hardness of this thin metal film by means of a "Dynamic Micro Hardness Tester" (manufactured by Shimadzu Corporation). As a result, the hardness was 500.

### <Example 3>

A sheet-like probe (10) according to the present invention was produced in the same manner as in Example 1 except that in the formation of the electrode members (16) in Example 1, a plating solution "Nickel Sulfite" (product of Nippon Chemical Industrial Co., Ltd.) containing nickel sulfamate was used as the plating solution in place of "NIPHOLLOY PROCESS" (product of Kizai Corporation), the treating temperature of the electroplating treatment was changed from 55°C to 40°C, and the treating time was changed from 35 minutes to 30 minutes.

The shapes and dimensions of the respective parts of the sheet-like probe (10) thus obtained were the same as in the sheet-like probe (10) according to Example 1.

The composition of the material forming the front-surface electrode parts (16) was analyzed by means of an Auger electron spectrometer. As a result, it was found to contain 100% by weight of nickel.

A thin metal film having a thickness of 5 µm was formed on a silicon wafer by an electroplating treatment under the same conditions as in the formation of the front-surface electrode parts (16) to measure a Vickers hardness of this thin metal film by means of a "Dynamic Micro Hardness Tester" (manufactured by Shimadzu Corporation). As a result, the hardness was 300.

### <Comparative Example 1>

A comparative sheet-like probe was produced in the following manner in accordance with the process shown in Fig. 40.

A laminate material (90A) obtained by laminating a metal layer (92) having a thickness of 5 µm and formed of copper on one surface of an insulating film (91) having a thickness of 12.5 µm and composed of polyimide was provided, and 19,650 through-holes (98H) of 30 µm in diameter each extending through in a thickness-wise direction of the insulating film (91) were formed in the insulating sheet (91) in the laminate material (90A) in accordance with a pattern corresponding to the pattern of the electrodes to be inspected in Wafer W for test by laser beam machining.

The laminate material (90A) was then subjected to photolithography and an electroplating treatment using a plating solution "Nickel Sulfite" (product of Nippon Chemical Industrial Co., Ltd.) containing nickel sulfamate, thereby forming short circuit parts (98) integrally joined to the metal layer (92) in the respective through-holes (91H) of the insulating film (91), and at the same time, forming projected front-surface electrode parts (96) integrally joined to the respective short circuit parts (98) on the front surface of the insulating film (91). The diameter of the proximal end of each of the front-surface electrode parts (96) was 70µm, and the height from the front surface of the insulating film (91) was 20 µm.

Thereafter, the metal layer (92) in the laminate material (90A) was subjected to a photoetching treatment to remove a part thereof, thereby forming rectangular back-surface electrode parts (97) each having dimensions of 80 µm x 200 µm to form electrode structures (95).

The surface of a peripheral edge portion in the insulating film (91) was then coated with a 2-pack type acrylic adhesive "Y-620" (product of Cemedine Co., Ltd.), a ring-like holding member composed of silicon nitride and having an outer diameter of 22 cm, an inner diameter of 20.5 cm and a thickness of 2 mm was arranged, and the holding member and the insulating film (91) were pressurized under a load of 50 kg and held for 8 hours at 25°C, thereby fixing the holding member to the insulating film (91), thus producing a comparative sheet-like probe.

The shapes and dimensions of each of the electrode structures (95) of the sheet-like probe thus obtained were as follows.

The front-surface electrode part (96) was in a semispherical form having a diameter of 70 µm and a projected height of about 20 µm.

The short circuit part (98) was in a columnar form having a diameter of 30 µm.

The back-surface electrode part (97) was in a rectangular flat plate form having a width of 80 µm, a length of 200 µm and a thickness of 5 µm.

The composition of the material forming the front-surface electrode parts (16) was analyzed by means of an Auger electron spectrometer. As a result, it was found to contain 100% by weight of nickel.

A thin metal film having a thickness of 5 µm was formed on a silicon wafer by an electroplating treatment under the same conditions as in the formation of the front-surface electrode parts (16) to measure a Vickers hardness of this thin metal film by means of a "Dynamic Micro Hardness Tester" (manufactured by Shimadzu Corporation). As a result, the hardness was 300.

### <Comparative Example 2>

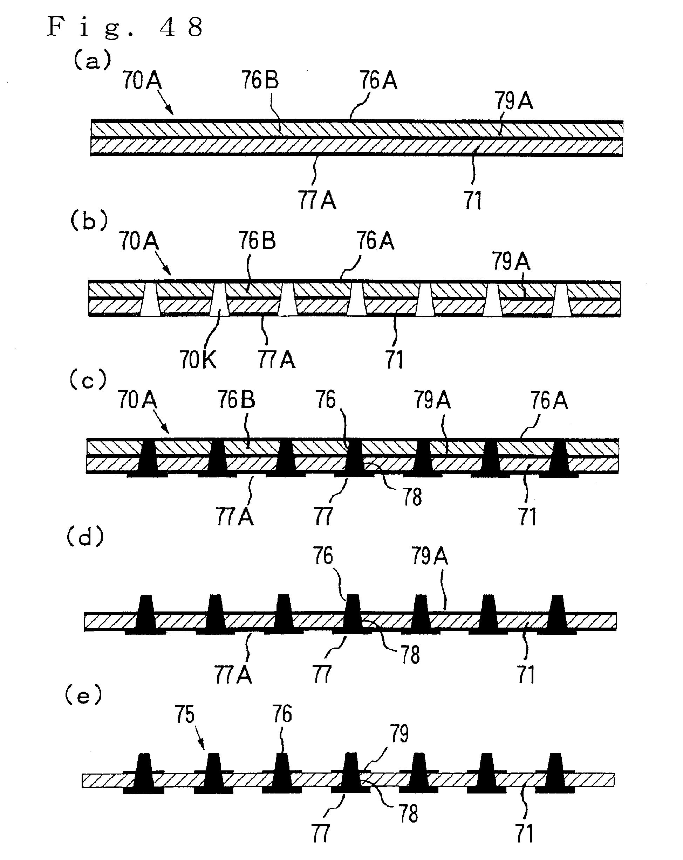

A comparative sheet-like probe was produced in the following manner in accordance with the process shown in Fig. 48.

A laminate material (70A) obtained by laminating a first front surface-side metal layer (79A) composed of copper and having a thickness of 4 µm, an insulating layer (76B) composed of polyimide and having a thickness of 12.5 µm and a second front surface-side metal layer (76A) composed of copper and having a thickness of 4 µ on a front surface of an insulating film (71) composed of polyimide and having a thickness of 37.5 µm in this order, and laminating a back surface-side metal layer (77A) composed of 42 alloy and having a thickness of 10 µm on a back surface of the insulating film (71) was provided (see Fig. 48(a)).

This laminate material (70A) was subjected to an etching treatment, thereby forming 19,650 recesses (70K) for forming electrode structures, each extending in the thickness-wise direction of the back surface-side metal layer (77A), the insulating film (71), the first front surface-side metal layer (79A) and the insulating layer (76B) and reaching the back surface of the second front surface-side metal layer (76A) (see Fig. 48(b)). Each of the recesses (70K) for forming electrode structures had a truncated cone form that the diameter becomes gradually small from the back surface-side metal layer (77A) toward the insulating film (71), the diameter of an opening in the back surface-side metal layer (77A) was 90 µm, and the diameter of an opening in the front surface of the insulating layer (76B) was 13 µm on the average.

Resist films were then formed on the front surface and back surface of the laminate material (70A), in which the recesses (70K) for forming electrode structures had been formed, by photolithography, and the thus-treated laminate material (70A) was immersed in a plating solution "Nickel Sulfite" (product of Nippon Chemical Industrial Co., Ltd.) containing nickel sulfamate to subject the laminate material (70A) to an electroplating treatment using the second front surface-side metal layer (76A) as an electrode, whereby the metal was filled into the respective recesses (70K) for forming electrode structures to form front-surface electrode parts (76) each protruding from the front surface of the insulating film (71), short circuit parts (78) each extending in the thickness-wise direction of the insulating film (71) continuously from the proximal end of the front-surface electrode part (76), and back-surface electrode parts (77) joined to the respective short circuit parts (78) and exposed to the back surface of the insulating film (71) (see Fig. 48(c)). Here, the back-surface electrode parts (77) are in a state connected to one another through the back surface-side metal layer (77A).

The second front surface-side metal layer (76A) and the insulating layer (76B) were then removed by respective etching treatments (see Fig. 48(d)), and the first front surface-side metal layer (79A) was then subjected to photolithography and an etching treatment, thereby forming disc ring-like holding parts (79) each continuously extending from a peripheral surface of a proximal end portion of the front-surface electrode part (76) outward and radially along the front surface of the insulating film (71), and moreover the back surface-side metal layer (77A) was subjected to photolithography and an etching treatment to remove the whole thereof, thereby separating the back-surface electrode parts (77) from one another, thus forming the electrode structures (75) (see Fig. 48(e)).

The surface of a peripheral edge portion in the insulating film (71) was then coated with a 2-pack type acrylic adhesive "Y-620" (product of Cemedine Co., Ltd.), a ring-like holding member composed of silicon nitride and having an outer diameter of 22 cm, an inner diameter of 20.5 cm and a thickness of 2 mm was arranged, and the holding member and the insulating film (71) were pressurized under a load of 50 kg and held for 8 hours at 25°C, thereby fixing the holding member to the insulating film (71), thus producing a comparative sheet-like probe.

The shapes and dimensions of each of the electrode structures (75) of the sheet-like probe thus obtained were as follows.

The front-surface electrode part (76) was in a truncated cone form having diameters of 37 µm at its proximal end and 13 µm on the average at its distal end and a projected height of 12.5 µm.

The short circuit part (78) was in a truncated cone form having diameters of 37 µm at one end on the front surface side and 90 µm at the other end on the back surface side.

The back-surface electrode part (77) was in a rectangular flat plate form having a width of 90 µm, a length of 200 µm and a thickness of 20 µm.

The holding part (79) was in a disk form having a diameter of 60 µm and a thickness of 4 µm.

The composition of the material forming the front-surface electrode parts (76) was analyzed by means of an Auger electron spectrometer. As a result, it was found to contain 100% by weight of nickel.

A thin metal film having a thickness of 5 µm was formed on a silicon wafer by an electroplating treatment under the same conditions as in the formation of the front-surface electrode parts (76) to measure a Vickers hardness of this thin metal film by means of a "Dynamic Micro Hardness Tester" (manufactured by Shimadzu Corporation). As a result, the hardness was 300.

### <Production of anisotropically conductive connector>

(1) Preparation of magnetic core particles:
   Commercially available nickel particles (product of Westaim Co., "FC1000") were used to prepare magnetic core particles in the following manner.
   An air classifier "Turboclassifier TC-15N" manufactured by Nisshin Engineering Co., Ltd. was used to classify 2 kg of nickel particles under conditions of a specific gravity of 8.9, an air flow of 2.5 m³/min, a rotor speed of 2,250 rpm, a classification point of 15 µm and a feed rate of nickel particles of 60 g/min, thereby collecting 0.8 kg of nickel particles having a particle diameter of 15 µm or smaller, and 0.8 kg of these nickel particles were further classified under conditions of a specific gravity of 8.9, an air flow of 2.5 m³/min, a rotor speed of 2,930 rpm, a classification point of 10 µm and a feed rate of nickel particles of 30 g/min to collect 0.5 kg of nickel particles.
   The nickel particles thus obtained had a number average particle diameter of 7.4 µm, a coefficient of variation of particle diameter of 27%, a BET specific surface area of 0.46 x 10³ m²/kg and a saturation magnetization of 0.6 Wb/m².
   The nickel particles are referred to as "Magnetic Core Particles [A]".
(2) Preparation of conductive particles:
   Into a treating vessel of a powder plating apparatus, were poured 100 g of Magnetic Core Particles [A], and 2 L of 0.32N hydrochloric acid was further added. The resultant mixture was stirred to obtain a slurry containing Magnetic Core Particles [A]. This slurry was stirred at ordinary temperature for 30 minutes, thereby conducting an acid treatment for Magnetic Core Particles [A]. Thereafter, the slurry thus treated was left at rest for 1 minute to precipitate Magnetic Core Particles [A], and a supernatant was removed.
   To the Magnetic Core Particles [A] subjected to the acid treatment, was added 2 L of purified water, and the mixture was stirred at ordinary temperature for 2 minutes. The mixture was then left at rest for 1 minute to precipitate Magnetic Core Particles [A], and a supernatant was removed. This process was conducted repeatedly twice, thereby conducting a washing treatment for Magnetic Core Particles [A].
   To the Magnetic Core Particles [A] subjected to the acid treatment and washing treatment, was added 2 L of a gold plating solution containing gold in a proportion of 20 g/L. The temperature of the treating vessel was raised to 90°C and the contents were stirred, thereby preparing a slurry. While stirring the slurry in this state, Magnetic Core Particles [A] were subjected to displacement plating with gold. Thereafter, the slurry was left at rest while allowing it to cool, thereby precipitating particles, and a supernatant was removed to prepare conductive particles.
   To the conductive particles obtained in such a manner, was added 2 L of purified water, and the mixture was stirred at ordinary temperature for 2 minutes. Thereafter, the mixture was left at rest for 1 minute to precipitate conductive particles, and a supernatant was removed. This process was conducted repeatedly further twice, and 2 L of purified water heated to 90°C was then added to the particles, and the mixture was stirred. The resultant slurry was filtered through filter paper to collect conductive particles. The conductive particles thus obtained were dried in a dryer set to 90°C.
   The resultant conductive particles had a number average particle diameter of 7.3 µm and a BET specific surface area of 0.38 x 10³ m²/kg, and a value of (mass of gold forming a coating layer/mass of Magnetic Core Particles [A]) was 0.3.
   The conductive particles are referred to as "Conductive Particles (a)".
(3) Production of frame plate:
   A frame plate (31) having a diameter of 8 inches and 393 openings (32) formed corresponding to the respective regions of the electrodes to be inspected in Wafer W for test described above was produced under the following conditions in accordance with the construction shown in Figs. 36 and 37.
   A material of this frame plate (31) is covar (coefficient of linear thermal expansion: 5 x 10⁻⁶/K), and the thickness thereof is 60 µm.
   The openings (32) each have dimensions of 6,400 µm in a lateral direction (upper and lower direction in Fig. 37) and 320 µm in a vertical direction(left and right direction in Fig. 37).
(4) Preparation of molding material for anisotropically conductive sheet:
   To 100 parts by weight of addition type liquid silicone rubber, were added 30 parts by weight of Conductive Particles [a] to mix them. Thereafter, the resultant mixture was subjected to a defoaming treatment by pressure reduction, thereby preparing a molding material for anisotropically conductive sheet.
   In the above-described process, the addition type liquid silicone rubber used is of a two-pack type composed of Liquid A and Liquid B each having a viscosity of 250 Pa·s. The cured product thereof has a compression set of 5%, a durometer A hardness of 32 and tear strength of 25 kN/m.
   In the present invention, properties of the addition type liquid silicone rubber and the cured product thereof were measured in the following manner.
      (i) The viscosity of the addition type liquid silicone rubber was a value measured by means of a Brookfield type viscometer at 23 ± 2°C.
      (ii) The compression set of the cured silicone rubber was measured in the following manner.
         Liquid A and Liquid B in the two-pack type liquid silicone rubber were stirred and mixed in proportions that their amounts become equal. After the mixture was then poured into a mold and subjected to a defoaming treatment by pressure reduction, it was subjected to a curing treatment under conditions of 120°C for 30 minutes, thereby forming a columnar body composed of the cured silicone rubber and having a thickness of 12.7 mm and a diameter of 29 mm. This columnar body was post-cured under conditions of 200°C for 4 hours. The columnar body obtained in such a manner was used as a specimen to measure a compression set at 150 ± 2°C in accordance with JIS K 6249.
      (iii) The tear strength of the cured silicone rubber was measured in the following manner.
         The curing treatment and post-curing of the addition type liquid silicone rubber were conducted under the same conditions as those in the item (ii) to form a sheet having a thickness of 2.5 mm. A crescent type specimen was produced by punching from this sheet to measure its tear strength at 23 ± 2°C in accordance with JIS K 6249.
      (iv) The durometer A hardness was determined by using, as a specimen, a laminate obtained by stacking 5 sheets produced in the same manner as in the item (iii) on one another, and measuring a value at 23 ± 2°C in accordance with JIS K 6249.
(5) Production of anisotropically conductive connector:
   The frame plate (31) produced in the item (1) and the molding material prepared in the item (4) were used to form 393 anisotropically conductive sheets (35) of the construction shown in Fig. 36, which were arranged so as to close the respective openings (32) in the frame plate (31) and fixed to and supported by respective opening edges of the frame plate (31), in accordance with the process described in Japanese Patent Application Laid-Open No. 2002-324600, thereby producing an anisotropically conductive connector. Here, the curing treatment of the molding material layers was conducted under conditions of 100°C for 1 hour while applying a magnetic field of 2 T in a thickness-wise direction of each molding material layer by electromagnets.
   The resultant anisotropically conductive sheets (35) will be described specifically. Each of the anisotropically conductive sheets (35) has dimensions of 7,000 µm in a lateral direction and 1,200 µm in a vertical direction, and 50 conductive parts (36) are arranged at a pitch of 120 µm in a line in the lateral direction. With respect to each of the conductive parts (36), its dimensions are 40 µm in the lateral direction and 200 µm in the vertical direction, the thickness is 150 µm, the projected height of the projected portion (38) is 25 µm, and the thickness of the insulating part (37) is 100 µm. Conductive parts for non-connection are arranged between the conductive part (36) located most outside in the lateral direction and the opening edge of the frame plate. Each of the conductive parts for non-connection has dimensions of 60 µm in the lateral direction and 200 µm in the vertical direction and a thickness of 150 µm.
   The content of the conductive particles in the conductive parts (36) in each of the anisotropically conductive sheets (35) was investigated. As a result, the content was about 25% in terms of a volume fraction in all the conductive parts (36).
   The anisotropically conductive connector was produced in such a manner.

### <Production of circuit board for inspection>

Alumina ceramic (coefficient of linear thermal expansion: 4.8 x 10⁻⁶/K) was used as a board material to produce a circuit board (20) for inspection, in which inspection electrodes (21) had been formed in accordance with a pattern corresponding to the pattern of the electrodes to be inspected in Wafer W for test. This circuit board (20) for inspection has dimensions of 30 cm x 30 cm as a whole and is rectangular. The inspection electrodes thereof each have dimensions of 60 µm in the lateral direction and 200 µm in the vertical direction. The resultant circuit board for inspection is referred to as "Circuit Board T1 for inspection".

### <Evaluation of sheet-like probe>

(1) Connection stability test:
The sheet-like probes according to Examples 1 to 3 and Comparative Examples 1 and 2 were respectively subjected to a connection stability test in the following manner.
Wafer W for test was first heated for 3 hours at 150°C by a thermostat to form an oxide film composed of aluminum oxide on the surfaces of the electrodes to be inspected composed of aluminum in Wafer W for test.
The this-treated Wafer W for test was then arranged on a test table at room temperature (25°C), a sheet-like probe was arranged on the surface of Wafer W for test in alignment in such a manner that the respective front-surface electrode parts thereof are located on the electrodes to be inspected of Wafer W for test, and the anisotropically conductive connector was arranged on this sheet-like probe in alignment in such a manner that the respective conductive parts thereof are located on the back-surface electrode parts of the sheet-like probe. Circuit Board T1 for inspection was arranged on this anisotropically conductive connector in alignment in such a manner that the respective inspection electrodes thereof are located on the conductive parts of the anisotropically conductive connector. Further, Circuit Board T1 for inspection was pressurized downward under a load of 20 kg (load applied to every electrode structure: about 1 g on the average).
With respect to 19,650 inspection electrodes in Circuit Board T1 for inspection, an electric resistance between every two electrodes electrically connected to each other through the sheet-like probe, the anisotropically conductive Connector and Wafer W for test was successively measured, and a half value of the electric resistance value measured was recorded as an electric resistance (hereinafter referred to as "conduction resistance") between an inspection electrode of Circuit Board T1 for inspection and an electrode to be inspected of Wafer W for test.
Circuit Board T1 for inspection was then pressurized downward under a load of 40 kg (load applied to every electrode structure: about 2 g on the average), and a conduction resistance was measured in this state.
Further, the load applied to Circuit Board T1 for inspection was changed to 60 kg (load applied to every electrode structure: about 3 g on the average), 80 kg (load applied to every electrode structure: about 4 g on the average) and 100 kg (load applied to every electrode structure: about 5 g on the average) to measure conduction resistances.
The results are shown in Table 1.

**[Table 1]**

| | **Conduction Resistance (Ω)** | | | | |
|---|---|---|---|---|---|
| **Load** | **2 0 k g** | **4 0 k g** | **6 0 k g** | **8 0 k g** | **100 k g** |
| **Example 1** | **0. 2 3** | **0. 1 0** | **0. 0 8** | **0. 0 6** | **0. 0 5** |
| **Example 2** | **0. 3 5** | **0. 1 3** | **0. 0 9** | **0. 0 7** | **0. 0 7** |
| **Example 3** | **0. 5 3** | **0. 1 4** | **0. 0 9** | **0. 0 8** | **0. 0 8** |
| **Comparative Example 1** | **1. 4 4** | **0. 9 7** | **0. 9 2** | **0. 8 6** | **0. 8 1** |
| **Comparative Example 2** | **1. 2 6** | **0. 2 5** | **0. 1 7** | **0. 1 4** | **0. 1 2** |

(2) Durability test:
The sheet-like probes according to Examples 1 to 3 and Comparative Example 2 were respectively subjected to a durability test in the following manner.
Wafer W for test was arranged on a test table equipped with an electric heater, a sheet-like probe was arranged on the surface of Wafer W for test in alignment in such a manner that the respective front-surface electrode parts thereof are located on the electrodes to be inspected of Wafer W for test, and the anisotropically conductive connector was arranged on this sheet-like probe in alignment in such a manner that the respective conductive parts thereof are located on the back-surface electrode parts of the sheet-like probe. Circuit Board T1 for inspection was arranged on this anisotropically conductive connector in alignment in such a manner that the respective inspection electrodes thereof are located on the conductive parts of the anisotropically conductive connector. Further, Circuit Board T1 for inspection was pressurized downward under a load of 60 kg (load applied to every electrode structure: about 3 g on the average). The test table was then heated to 85°C and held for 30 seconds in this state. Thereafter, the pressurization to Circuit Board T1 for inspection was released while keeping the temperature of the test table at 85°C, and Circuit Board T1 for inspection was held for 30 seconds in this state. This process was regarded as a cycle, and the cycle was repeated 20,000 times in total.
After the above-described durability test was completed, the holding parts of the electrode structures in the sheet-like probe were observed.
As a result, in the sheet-like probes according to Examples 1 to 3, the holding parts in all the electrode structures did not separate from the respective insulating films at all, while in the sheet-like probe according to Comparative Example 2, the holding parts in part of the electrode structures separated from the respective insulating films.

## Claims

1. A sheet-like probe comprising a contact film obtained by arranging, in a flexible insulating film, a plurality of electrode structures extending through in a thickness-wise direction of the insulating film in a state separated from one another in a plane direction of the insulating film, wherein
each of the electrode structures is exposed to the surfaces of the insulating film and composed of a front-surface electrode part projected from a front surface of the insulating film, a back-surface electrode part exposed to a back surface of the insulating film, a short circuit part directly joined to the front-surface electrode part and the back-surface electrode part for electrically connecting them and extending in a thickness-wise direction of the insulating film, and a holding part formed at a proximal end portion of the front-surface electrode part and extending in the plane direction of the insulating film, and wherein
at least a part of the holding part is embedded in the insulating film.

2. The sheet-like probe according to claim 1, wherein the insulating film is formed by a base layer composed of a resin and a surface layer integrally laminated on this base layer and composed of an adhesive resin or a cured product thereof.

3. The sheet-like probe according to claim 1 or 2, wherein the short circuit parts are formed by subjecting proximal ends of the front-surface electrode parts to a plating treatment.

4. The sheet-like probe according to claim 3, wherein the front-surface electrode parts and the short circuit parts are composed of different metals from each other.

5. The sheet-like probe according to claim 4, wherein the Vickers hardness (Hv) of the metal forming the front-surface electrode parts is at least 40.

6. The sheet-like probe according to any one of claims 1 to 5, wherein the probe has a supporting film composed of a metal, in which opening has been formed, and the contact film is supported on the surface of the supporting film in such a manner that the respective electrode structures are located in the opening in the supporting film.

7. The sheet-like probe according to claim 6, wherein the supporting film has a plurality of openings.

8. The sheet-like probe according to claim 7, which comprises a plurality of contact films each supported by the supporting film.

9. The sheet-like probe according to any one of claims 1 to 8, wherein the front-surface electrode part in each electrode structure has a shape that its diameter becomes gradually small from the proximal end toward the distal end thereof.

10. The sheet-like probe according to any one of claims 1 to 9, wherein the value of a ratio h/R₁ of the projected height h of the front-surface electrode part to the diameter R₁ of the proximal end of the front-surface electrode part in the electrode structure is 0.2 to 3.

11. A process for producing the sheet-like probe according to any one of claims 1 to 10, which comprises the steps of:
providing an electrode member-arranging plate, in which a plurality of recesses each having a shape fitted to a shape of a front-surface electrode part in each of electrode structures to be formed have been formed in a pattern corresponding to a pattern of the electrode structures, and an insulating film obtained by forming a surface layer composed of an adhesive resin on a base layer composed of a resin,
depositing a metal in the recesses of the electrode member-arranging plate and on peripheries thereabout, thereby forming electrode members each composed of a front-surface electrode part and a holding part extending in a plane direction of the electrode member-arranging plate from a distal end portion of the front-surface electrode part,
disposing the respective electrode members formed in the electrode member-arranging plate so as to be brought into contact with the surface layer of the insulating film and subjecting the members to a press-bonding treatment, thereby bonding the electrode members to the insulating film,
forming a plurality of through-holes each extending in a thickness-wise direction of the insulating film and linked to the front-surface electrode part in the electrode member in the insulating film, and
subjecting the front-surface electrode parts to a plating treatment to fill a metal into the through-holes in the insulating film, thereby forming short circuit parts each connected to the front-surface electrode part.

12. A process for producing the sheet-like probe according to any one of claims 6 to 8, which comprises the steps of:
providing an electrode member-arranging plate, in which a plurality of recesses each having a shape fitted to a shape of a front-surface electrode part in each of electrode structures to be formed have been formed in a pattern corresponding to a pattern of the electrode structures, and a laminate material composed of a metal film and an insulating film integrally laminated on a surface of the metal film and obtained by forming an adhesive surface layer on a base layer composed of a resin,
depositing a metal in the recesses of the electrode member-arranging plate and on peripheries thereabout, thereby forming electrode members each composed of a front-surface electrode part and a holding part extending in a plane direction of the electrode member-arranging plate from a distal end portion of the front-surface electrode part,
disposing the electrode members formed in the electrode member-arranging plate so as to be brought into contact with the surface layer of the insulating film in the laminate material and subjecting the members to a press-bonding treatment, thereby bonding the electrode members to the insulating film,
forming a plurality of through-holes each extending in a thickness-wise direction of the laminate material and linked to the front-surface electrode part in the electrode member in the laminate material,
subjecting the front-surface electrode parts to a plating treatment to fill a metal into the through-holes in the insulating film, thereby forming short circuit parts each connected to the front-surface electrode part, and
subjecting the metal film in the laminate material to an etching treatment, thereby forming a supporting film with opening formed therein.

13. The process according to claim 11 or 12 for producing the sheet-like probe, wherein each of the recesses formed in the electrode member-arranging plate has a shape that its diameter becomes gradually small from a front surface of the electrode member-arranging plate toward a back surface thereof.

14. A probe card for conducting electrical connection between a circuit device that is an object of inspection and a tester, which comprises:
a circuit board for inspection, on which a plurality of inspection electrodes have been formed corresponding to electrodes to be inspected of the circuit device, which is the object of inspection, an anisotropically conductive connector arranged on the circuit board for inspection, and the sheet-like probe according to any one of claims 1 to 10, which is arranged on the anisotropically conductive connector.

15. A probe card for conducting electrical connection between a circuit device that is an object of inspection and a tester, which comprises:
a circuit board for inspection, on which a plurality of inspection electrodes have been formed corresponding to electrodes to be inspected of the circuit device, which is the object of inspection, an anisotropically conductive connector arranged on the circuit board for inspection, and the sheet-like probe arranged on the anisotropically conductive connector and produced by the process according to claim 12 or 13.

16. The probe card according to claim 14 or 15, wherein the circuit device that is the object of inspection is a wafer, on which a great number of integrated circuits have been formed, the anisotropically conductive connector has a frame plate, in which a plurality of openings have been formed corresponding to electrode regions, in which electrodes to be inspected have been arranged in the whole or part of the integrated circuits formed on the wafer, which is the object of inspection, and anisotropically conductive sheets arranged so as to close the respective openings in the frame plate.

17. An inspection apparatus for circuit devices, which comprises the probe card according to any one of claims 14 to 16.
